# EUROPEAN PATENT APPLICATION

(11) **EP 4 753 401 A1**
(43) Date of publication of application: **03.06.2026**
(21) Application number: 25218937.8
(22) Date of filing: 27.11.2025
(51) Int. Cl.: H10D 30/47, H10D 30/01, H10D 30/00, H10D 62/10, H10D 62/13, H10D 62/80

(54) **SEMICONDUCTOR DEVICE, ELECTRONIC APPARATUS INCLUDING THE SAME, AND METHOD OF MANUFACTURING THE SEMICONDUCTOR DEVICE**

(30) Priority: 27.11.2024 KR 20240172756; 25.11.2025 KR 20250181020
(71) Applicant: Samsung Electronics Co., Ltd., Suwon-si, Gyeonggi-do 16677 (KR)
(72) Inventor: Kim, Joonyun, 16678 Suwon-si, Gyeonggi-do (KR); Park, Baekwon, 16678 Suwon-si, Gyeonggi-do (KR); Kim, Sangwon, 16678 Suwon-si, Gyeonggi-do (KR); Yang, Eunji, 16678 Suwon-si, Gyeonggi-do (KR)
(74) Representative: Grünecker Patent- und Rechtsanwälte PartG mbB

(57) **Abstract**

Provided are semiconductor devices, electronic apparatuses including the same, and methods of manufacturing the semiconductor device. The semiconductor device includes a substrate, a patterning layer on the substrate, a channel arrange on the patterning layer and including a two-dimensional (2D) material, a source electrode and a drain electrode electrically connected to the channel, a gate electrode on the channel, and a gate insulating film between the channel and the gate electrode, wherein the channel may include a channel area having a relatively thin thickness and a contact area having relatively thick thickness.

## Description

### BACKGROUND

### 1. Field

The disclosure relates to semiconductor devices with reduced contact resistance, electronic apparatuses including the same, and/or methods of manufacturing the semiconductor device.

### 2. Description of the Related Art

A transistor is a semiconductor device with an electric switching function and is employed in various integrated circuit (IC) devices including memories, driving ICs, logic devices, etc. To increase the degree of integration of IC devices, the space occupied by transistors included in IC devices has been reduced, and research has been conducted to decrease the size of transistors while maintaining their performance.

Gate electrodes are one of the main parts of transistors. When a voltage is applied to a gate electrode, a channel adjacent to the gate electrode opens a pathway for a current or blocks the current in the opposite case. The performance of semiconductors depends on their capabilities to improve an on/off ratio, to reduce a contact resistance, and/or to reduce a leakage current in gate electrodes and channels.

### SUMMARY

Provided are semiconductor devices with reduced contact resistance.

The invention is what is claimed in the independent claims. Preferred embodiments are specified in the dependent claims.

Provided are electronic apparatuses including a semiconductor device with reduced contact resistance.

Provided are methods of manufacturing semiconductor device including a two-dimensional (2D) material channel.

Additional aspects will be set forth in part in the description which follows and, in part, will be apparent from the description, or may be learned by practice of the presented example embodiments of the disclosure.

According to an example embodiment of the disclosure, a semiconductor device includes a substrate, a patterning layer on the substrate, a channel on the patterning layer and including a two-dimensional (2D) material, a source electrode and a drain electrode electrically connected to the channel, a gate electrode on the channel, and a gate insulating film between the channel and the gate electrode, wherein the channel includes a channel area having a relatively thin thickness and a contact area having a relatively thick thickness, the channel includes an upper surface and a lower surface, the upper surface of the channel being farther from the substrate than the lower surface of the channel, the lower surface of the channel including a lower surface of the channel area and a lower surface of the contact area, and a first distance from the lower surface of the channel area to an upper surface of the substrate is greater than a second distance from the lower surface of the contact area to the upper surface of the substrate.

The upper surface of the channel may be a flat plane.

The channel may have a structure in which a plurality of 2D material layers are stacked, and a first number of the plurality of 2D material layers of the channel area may be less than a second number of the plurality of 2D material layers of the contact area.

The second number of the plurality of 2D material layers of the contact area may be 5 to 20.

The channel may include at least one of a transition metal dichalcogenide (TMD) material, graphene, black phosphorus, amorphous boron nitride, or phosphorene.

The patterning layer may include a high-k material or a ferroelectric material.

The patterning layer may include a first patterning layer on the substrate and a second patterning layer under the channel area.

A lower gate electrode may be further between the substrate and the patterning layer.

The channel may include a plurality of channel areas being apart from each other in a direction away from substrate and a plurality of contact areas extending from the plurality of channel areas, respectively, and a distance from the lower surface of one of the plurality of channel areas to the upper surface of the substrate is greater than a distance from the lower surface of one of the plurality of contact areas extending from the one of the plurality of channel areas to the upper surface of the substrate.

The contact areas on a first side of each of the plurality of channel areas may be continuously connected to each other, and , and the contact area on a second side of each of the plurality of channel areas opposite to the first side may be continuously connected to each other.

Another patterning layer, another channel, another gate insulating film, and another gate electrode may be further on the gate electrode, and the another channel may include a material having a different conductivity type than that of a material of the channel.

According to an example embodiment of the disclosure, a method of manufacturing a semiconductor device includes forming a patterning layer, forming an adjustment layer on the patterning layer, forming a channel by depositing a precursor of a two-dimensional material on the patterning layer and the adjustment layer forming a source electrode and a drain electrode on the channel, forming a gate electrode over the source electrode and the drain electrode, and forming a gate insulating film between the channel and the gate electrode, wherein the adjustment layer includes a material having a relatively low adsorption capacity with respect to the precursor of the two-dimensional material, compared to the patterning layer, and the adjustment layer includes a plurality of adjustment layers having different thicknesses.

The method may further include removing the adjustment layer.

The adjustment layer may include a plurality of thicker adjustment layers and a thinner adjustment layer between an adjacent pair of the plurality of thicker adjustment layers.

A pocket may be formed between one of the plurality of thicker adjustment layers and the thinner adjustment layer.

The patterning layer may include a high-k material and a ferroelectric material.

The adjustment layer may include at least one of SiO₂, Al₂O₃, SiN, or an amorphous carbon layer.

A first height of the second adjustment layer may be greater than a second height of the stacked structure.

According to an example embodiment of the disclosure, an electronic apparatus includes a memory including the aforementioned semiconductor device and a memory controller, configured to control the memory.

According to an example embodiment of the disclosure, a semiconductor device includes a substrate, a first patterning layer on the substrate, a plurality of vertically stacked channels on the first patterning layer, each of the plurality of vertically stacked channels including a two-dimensional (2D) material, each of the plurality of vertically stacked channels including a channel area having a relatively thin thickness and a first contact area and a second contact area having a relatively thick thickness at both sides of the channel area, respectively, each of the plurality of vertically stacked channels including an upper surface and a lower surface closer to the substrate than the upper surface, the lower surface including a first lower surface portion of the channel area and a second lower surface portion of each of the first contact area and the second contact areas, the second lower surface portion of each of the first contact area and the second contact areas of one of the plurality of vertically stacked channels being in direct contact with the upper surface of another one of the plurality of vertically stacked channels that is immediately under the one of the plurality of vertically stacked channels, a source electrode electrically connected to the first contact area of each of the plurality of vertically stacked channels, a drain electrode electrically connected to the second contact area of each of the plurality of vertically stacked channels, and gate structure between the source electrode and the drain electrode, the gate structure including a gate insulating layer and a gate electrode, the gate structure enclosing each of the plurality of vertically stacked channels on top, bottom and lateral surfaces thereof, in a cross-section traversing from the source electrode to the drain electrode, wherein each of the first contact area and the second contact area has a structure in which a plurality of two-dimensional material layers are stacked in parallel, and the channel area has a structure in which a plurality of two-dimensional material layers are stacked in parallel, and a first stacking direction of the plurality of first two-dimensional material layers of each of the first contact area and the second contact area and a second stacking direction of the plurality of second two-dimensional material layers of the channel area are same.

The second lower surface portion of each of the first contact area and the second contact area of one of the plurality of vertically stacked channels may be in direct contact with the upper surface of another one of the plurality of vertically stacked channels that is immediately under the one of the plurality of vertically stacked channels.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1A is a schematic cross-sectional view of a semiconductor device according to an example embodiment;
FIG. 1B is a diagram illustrating an example in which a lower gate electrode is further provided in the semiconductor device of FIG. 1A;
FIG. 2 is a schematic cross-sectional view of a semiconductor device according to another example embodiment;
FIG. 3A is a perspective view of a semiconductor device according to another example embodiment;
FIG. 3B is a cross-sectional view taken along line A-A' of FIG. 3A;
FIG. 4 is a schematic cross-sectional view of a semiconductor device according to another example embodiment;
FIG. 5 is diagram illustrating a method of manufacturing a semiconductor device according to an example embodiment;
FIGS. 6 to 16 are diagrams each illustrating a method of manufacturing a semiconductor device according to an example embodiment;
FIG. 17 is a diagram illustrating two-dimensional (2D) material deposition by using two materials having different surface adsorption capacity for a precursor of a 2D material from each other in a method of manufacturing a semiconductor device, according to an example embodiment;
FIG. 18 shows transmission electron microscope (TEM) images of areas B1 and B2 of FIG. 17;
FIG. 19 shows energy dispersive X-ray spectroscopy (EDX) analysis results for areas B1 and B2 of FIG. 17;
FIG. 20 is a schematic view of a semiconductor device manufactured according to a manufacturing method according to an example embodiment;
FIG. 21 is a schematic view of a semiconductor device manufactured according to a manufacturing method according to a comparative example;
FIGS. 22 to 33 are diagrams each illustrating a method of manufacturing a semiconductor device according to another example embodiment;
FIG. 34 is a schematic block diagram of a display driver integrated circuit (DDI) including a semiconductor device and a display apparatus including the DDI, according to an example embodiment;
FIG. 35 is a circuit diagram of a complementary metal-oxide semiconductor (CMOS) inverter including a semiconductor device according to an example embodiment;
FIG. 36 is a circuit diagram of a CMOS static random-access memory (SRAM) device including a semiconductor device according to an example embodiment;
FIG. 37 is a circuit diagram of a CMOS NAND circuit including a semiconductor device according to an example embodiment;
FIG. 38 is a block diagram of an electronic apparatus including a semiconductor device according to an example embodiment; and
FIG. 39 is a block diagram of an electronic apparatus including a semiconductor device according to an example embodiment.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

Hereinafter, a semiconductor device according to various example embodiments, an electronic apparatus including the same, and a method of manufacturing the semiconductor device will be described in detail with reference to the accompanying drawings. In the drawings, like reference numerals in the drawings denote like elements, and sizes of components in the drawings may be exaggerated for clarity and convenience of explanation. While such terms as "first," "second," etc., may be used to describe various components, such components must not be limited to the above terms. The above terms are used only to distinguish one component from another.

An expression used in the singular encompasses the expression of the plural, unless it has a clearly different meaning in the context. When a portion "includes" a component, another component may be further included, rather than excluding the existence of the other component, unless otherwise described. Sizes or thicknesses of components in the drawings may be arbitrarily exaggerated for convenience of explanation. Further, when a certain material layer is described as being arranged on a substrate or another layer, the material layer may be in contact with the other layer, or there may be a third layer between the material layer and the other layer. In example embodiments, materials constituting each layer are provided merely as an example, and other materials may also be used.

Moreover, the terms "part," "module," etc. refer to a unit processing at least one function or operation, and may be implemented by a hardware, a software, or a combination thereof.

The particular implementations shown and described herein are illustrative examples of example embodiments and are not intended to otherwise limit the scope of example embodiments in any way. For the sake of brevity, conventional electronics, control systems, software development and other functional aspects of the systems may not be described in detail. Furthermore, the connecting lines, or connectors shown in the various figures presented are intended to represent exemplary functional relations and/or physical or logical couplings between the various elements. It should be noted that many alternative or additional functional relations, physical connections or logical connections may be present in a practical device.

The use of the terms "a" and "an" and "the" and similar referents in the context of describing example embodiments (especially in the context of the following claims) are to be construed to cover both the singular and the plural.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

Also, the steps of all methods described herein can be performed in any suitable order unless otherwise indicated herein or otherwise clearly contradicted by context. The use of any and all exemplary language (e.g., "such as") provided herein, is intended merely to better illuminate technical ideas and does not pose a limitation on the scope of example embodiments unless otherwise claimed.

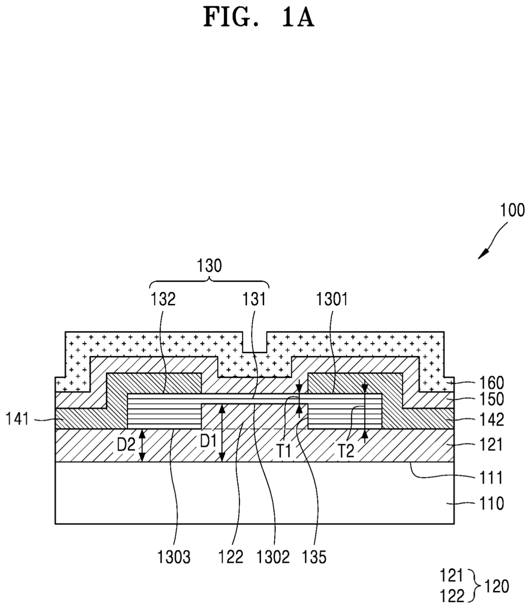

FIG. 1A is a schematic view of a semiconductor device according to an example embodiment.

A semiconductor device 100 according to an example embodiment may include a substrate 110, a patterning layer 120 arranged on the substrate 110, a channel 130 arranged on the patterning layer 120 and including a two-dimensional (2D) material, a source electrode 141 and a drain electrode 142 that are electrically connected to the channel 130, a gate electrode 160 arranged apart from the channel 130, and a gate insulating film 150 arranged between the channel 130 and the gate electrode 160.

The substrate 110 may be an insulating substrate or a semiconductor substrate on which an insulating layer is formed. The substrate 110 may include, for example, Si, SiO₂, Ge, SiGe, Group III-V semiconductor materials, etc. However, the disclosure is not limited thereto.

The patterning layer 120 may be a layer for patterning a structure of the channel 130 and may include a high-k material or a ferroelectric material. High k or high permittivity may refer to a permittivity higher than that of a silicon oxide. The patterning layer 120 may be an oxide including at least one of Ca, Sr, Ba, Sc, Y, La, Ti, Hf, Zr, Nb, Ta, Ce, Pr, Nd, Gd, Dy, Al, Yb, or Lu. The patterning layer 120 may include, for example, at least one of HfO₂, HfSiO, HfSiON, HfTaO, HfTiO, HfZrO, HfAlO, ZrO₂, Al₂O₃, or ZrAlO₂.

The channel 130 may be connected between the source electrode 141 and the drain electrode 142 and may be a path through which a current flows between the source electrode 141 and the drain electrode 142. The channel 130 may be in direct contact with the source electrode 141 and the drain electrode 142. However, the channel 130 is not limited thereto, and the channel 130 may be connected to the source electrode 141 and the drain electrode 142 through another medium.

The channel 130 may include a contact area 132 that is relatively thick and a channel area 131 that is relatively thin. That is, a thickness T2 of the contact area 132 may be greater than a thickness T1 of the channel area 131. The contact area 132 may be an area facing the source electrode 141 and the drain electrode 142, and the channel area 131 may be an area between two contact areas 132. The thicknesses of the contact area 132 and the channel area 131 may not be constant. When the thicknesses are not constant, the thickness may refer to the greatest thickness of the thicknesses of each area.

The channel 130 may include an upper surface 1301 located relatively far from the substrate 110, a lower surface 1302 of the channel area 131, and a lower surface 1303 of the contact area 132. In the specification, the upper surface may refer to a surface located relatively far from the substrate 110, and the lower surface may refer to a surface located relatively close to the substrate 110. A distance D1 from the lower surface 1302 of the channel area 131 to an upper surface 111 of the substrate 110 may be greater than a distance D2 from the lower surface 1303 of the contact area 132 to the upper surface 111 of the substrate 110. The upper surface 1301 of the channel 130 may have a plane structure, and the lower surface of the channel 130 may have a non-plane structure. The lower surface of the channel 130 may include, for example, a plurality of surfaces having different distances to the substrate 110 from each other. For example, a trench 135 may be provided under the channel area 131. Due to such structure, the channel 130 may include the channel area 131 and the contact area 132 that have different thicknesses from each other.

The channel 130 may include a 2D material. The 2D material may include graphene, black phosphorus, phosphorene, amorphous boron nitride, or transition metal dichalcogenide (TMD). The TMD may include a metallic element selected from the group consisting of Mo, W, Nb, V, Ta, Ti, Zr, Hf, Tc, Re, Cu, Ga, In, Sn, Ge, and Pb and a chalcogen element selected from the group consisting of S, Se, and Te. The TMD may be represented by, for example, MX₂ where M represents a transition metal, and X represents a chalcogen element. For example, the TMD may include at least one of MoS₂, MoSe₂, MoTe₂, WS₂, WSe₂, WTe₂, ZrS₂, ZrSe₂, HfS₂, HfSe₂, NbSe₂, or ReSe₂. In some example embodiments, the TMD may not be represented by MX₂. For example, the TMD may include CuS which is a compound of Cu, a transition metal, and S, a chalcogen element. However, the foregoing materials are just an example, and other materials may be used as the TMD material.

The 2D material may be used in the channel 130 to implement a short channel length when the semiconductor device 100 is applied to a field effect transistor. The channel length may refer to a length of the channel 130 in a direction in which the source electrode 141 and the drain electrode 142 are apart. According to the recent tendency of miniaturization of electronic apparatuses, the channel length has decreased. When the channel length decreases, issues due to short channel effects may occur. To reduce or prevent such issues and effectively reduce the channel length, it may be advantageous to maintain a thin thickness for the channel 130. In other words, the thinner the thickness of the channel 130 is, the shorter the minimum implementable channel length may be.

The 2D material may have relatively good electrical characteristics, and even when the 2D material has a nano-scale thickness, the mobility thereof may remain relatively high. The 2D material may have a single-layer structure, or a multi-layer structure. Each layer of such 2D material may have an atomic-level thickness. The 2D material have properties that the bandgap and the Schottky barrier height (SBH) with respect to the electrode vary according to the thickness of unit lattice layer (e.g., the number of layers). When the thickness of the 2D material layers (e.g., the number of the 2D material layers) decreases, the bandgap may increase, and accordingly, the on/off ratio may also increase. However, when a difference between the bandgap of the 2D material layer and a work function increases, the SBH and contact resistance may increase, resulting in deterioration of on-current. When the thickness of the 2D material layer of the contact area 132 is relatively thick, the bandgap and the SBH with respect to the electrode may be reduced, and accordingly, the contact resistance may decrease. As such, the contact area 132 of the channel 130 may have a relatively thick thickness, and the channel area 131 may have a relatively thin thickness to implement a semiconductor device having a relatively high on-current while maintaining a relatively high on/off ratio.

During a deposition process of the source electrode 141 and the drain electrode 142, the channel 130 of the 2D material may be damaged. Due to the damage of the channel 130, a short circuit issue between the contact area 132 and the channel area 131 may occur, and selective adjustment of the thickness of the channel 130 of 2D material may resolve such issue. The selective thickness adjustment may be considered important when forming a stable contact in a 3D device structure such as Multi-Bridge-Channel Field Effect Transistor (MBCFET).

In some example embodiments, the contact area 132 may have a structure in which a plurality of two-dimensional material layers are stacked in parallel, and the channel area 131 may have a structure in which a plurality of two-dimensional material layers are stacked in parallel. The stacking direction of the two-dimensional material layers of the contact area 132 and the stacking direction of the two-dimensional material layers of the channel area 131 may be the same. In some example embodiments, the number of the two-dimensional material layers of the contact area 132 may be greater than the number of the two-dimensional material layers of the channel area 131. For example, a ratio of the number of layers of the contact area 132 to the number of layers of the channel area 131 may include a range from about 0.8 to about 25 or from about 1 to about 20. For example, the number of layers of the channel area 131 may include a range from 1 to 5 or from 1 to 3. The thickness of the channel area 131 may be greater than 0 nm and may be 10 nm or less, 5 nm or less, or about 3 nm or less. The thickness of the channel area 131 may be about 0.7 nm to about 2 nm. The thickness of the channel area 131 is not limited thereto and may be thinner. The number of layers of the contact area 132 may include a range from 5 to 25 or from 5 to 20. The thickness of the contact area 132 may be, for example, greater than 0 nm and may be 20 nm or less, 18 nm or less, or 15 nm or less. The thickness of the contact area 132 may be about 3.5 nm to about 15 nm.

When forming the contact area 132 and the channel area 131 to have different thicknesses from each other, the trench 135 may be provided under the channel area 131. By doing so, when forming the channel 130, the contact area 132 and the channel area 131 may be formed to have different thicknesses from each other through a selective growth process without an etching process. The absence of etching process may reduce or minimize damage on the channel 130. A manufacturing process of the channel 130 is to be described in detail later.

The patterning layer 120 may include a first patterning layer 121 arranged on the substrate 110 and a second patterning layer 122 arranged in the trench 135. The first patterning layer 121 may include a material adsorbing a precursor of the 2D material when the 2D material is deposited to form the channel 130. The first patterning layer 121 may include a material having a relatively high adsorption capacity with respect to the precursor of the 2D material. The second patterning layer 122 may include the same material as the first patterning layer 121. The first patterning layer 121 and the second patterning layer 122 may be from in different processes from each other.

The source electrode 141 and the drain electrode 142 may be arranged to be in contact with at least one of the upper surface or the lateral surface of the contact area 132 of the channel 130. The contact resistance of the semiconductor device 100 may be inversely proportional to the contact surface, and as the greater the number of layers of the contact area 132 is, the greater the contact surface in an edge direction may be, which leads to reduced contact resistance. When the contact area 132 is relatively thick, and a contact surface between the lateral surface of the contact area 132 and a corresponding one of the source electrode 141 and the drain electrode 142 increases, not only the SBH with respect to the electrode may decrease due to reduced bandgap, but also the contact resistance may be reduced due to the increased contact surface in the edge direction.

The source electrode 141 and the drain electrode 142 may include a metal material having electric conductivity. For example, the source electrode 141 and the drain electrode 142 may include metal such as magnesium (Mg), aluminum (Al), scandium (Sc), titanium (Ti), vanadium (V), chrome (Cr), manganese (Mn), nickel (Ni), copper (Cu), zinc (Zn), gallium (Ga), zirconium (Zr), niobium (Nb), molybdenum (Mo), lead (Pd), silver (Ag), cadmium (Cd), indium (In), tin (Sn), lanthanum (La), hafnium (Hf), tantalum (Ta), tungsten (W), iridium (Ir), platinum (Pt), gold (Au), bismuth (Bi), etc., or an alloy thereof.

The gate insulating film 150 may be provided on the source electrode 141, the channel 130, and the drain electrode 142. The gate insulating film 150 may include a high-k material or a ferroelectric material. An oxide including at least one of Ca, Sr, Ba, Sc, Y, La, Ti, Hf, Zr, Nb, Ta, Ce, Pr, Nd, Gd, Dy, Yb, or Lu may be used as the high-k material. Due to the non-centrosymmetric charge distribution in a crystallized material structure, the ferroelectric materials have spontaneous electric dipole (e.g., spontaneous polarization). Accordingly, the ferroelectric materials have remnant polarization by a dipole even when no electric field from outside is applied thereto. Moreover, a polarization direction may switch according to a domain unit by an external electric field. The ferroelectric material may include an oxide of at least one of Hf, Si, Al, Zr, Y, La, Gd, or Sr; however, this is only an example. In addition, the ferroelectric material may further include a dopant, when necessary.

The ferroelectric material may have at least one of a fluorite structure, a perovskite structure, or a wurtzite structure. The ferroelectric material having a fluorite structure may include, for example, a hafnium oxide (HfO). For example, the ferroelectric material may include a hafnium oxide and a dopant. The dopant may include, for example, at least one of zirconium (Zr), lanthanum (La), aluminum (Al), silicon (Si), or yttrium (Y). In another example embodiment, the ferroelectric material may include hafnium and zirconium at substantially the same element ratio (e.g., Hf_{0.5}Zr_{0.5}O₂) and may additionally be doped with at least one of lanthanum (La), aluminum (Al), silicon (Si), yttrium (Y), or gadolinium (Gd) at about 10 at%. The ferroelectric material having a perovskite structure may include, for example, lead zirconate titanate (PZT). The ferroelectric material having a perovskite structure may include, for example, a zinc oxide (ZnO) or an aluminum nitride (AIN).

The gate insulating film 150 may include, for example, at least one of HfO₂, HfSiO, HfSiON, HfTaO, HfTiO, HfZrO, HfAlO, ZrO₂, Al₂O₃, or ZrAlO₂. The gate insulating film 150 may have a single-layer structure as illustrated in the drawings; however, the disclosure is not limited thereto, and the gate insulating film 150 may have a multi-layer structure. For example, the gate insulating film 150 may have a multi-layer structure of ZrO₂/HfO₂/ZrO₂/HfO₂. The thickness of the gate insulating film 150 may be greater than 0 nm and less than or equal to 5 nm. However, the disclosure is not limited thereto.

When the gate insulating film 150 includes a ferroelectric material, the semiconductor device 100 may be applied to, for example, a logic device, a memory device, a display device, etc. When the gate insulating film 150 includes a ferroelectric material, the subthreshold swing (SS) may be reduced due to the negative capacitance effect, and accordingly, the size of the semiconductor device 100 may be reduced while improving the performance of the semiconductor device 100.

The gate insulating film 150 may have a multi-layer structure including a high-k material and a ferroelectric material. As the gate insulating film 150 includes a charge trapping layer such as a silicon nitride, the semiconductor device 100 may operate as memory transistor having memory characteristics.

The gate electrode 160 may be arranged on the gate insulating film 150. The gate electrode 160 may include a metal material or a conductive oxide. The metal material may include, for example, at least one selected from Au, Cr, Ru, Ti, TiN, TaN, W, Mo, WN, Pt, or Ni. The conductive oxide may include, for example, indium tin oxide (ITO), indium zinc oxide (IZO), etc. The gate electrode 160 may include polysilicon or single-crystal silicon. The gate electrode 160 may include the same material as the source electrode 141 and the drain electrode 142. However, the disclosure is not limited thereto, and the gate electrode 160 may include a material different from those of the source electrode 141 and the drain electrode 142.

As the semiconductor device 100 according to an example embodiment employs a 2D material, the short channel effect may be reduced, and the relatively short channel length may be implemented. The short channel effect may refer to limited performance due to a short channel length and may include, for example, threshold voltage variation, carrier velocity saturation, deterioration of the subthreshold characteristics, etc. It is known that the short channel effect is related to the thickness of a channel. The thinner the thickness of the channel is, the shorter the possible minimum channel length may be. Accordingly, when implementing a micro transistor to increase a degree of integration, the channel length may be effectively reduced by reducing the channel thickness. In this manner, in the semiconductor device 100, the channel length may be reduced by reducing the thickness of the channel area 131 and decrease the contact resistance by simultaneously increasing the thickness of the contact area 132 relative to the channel area.

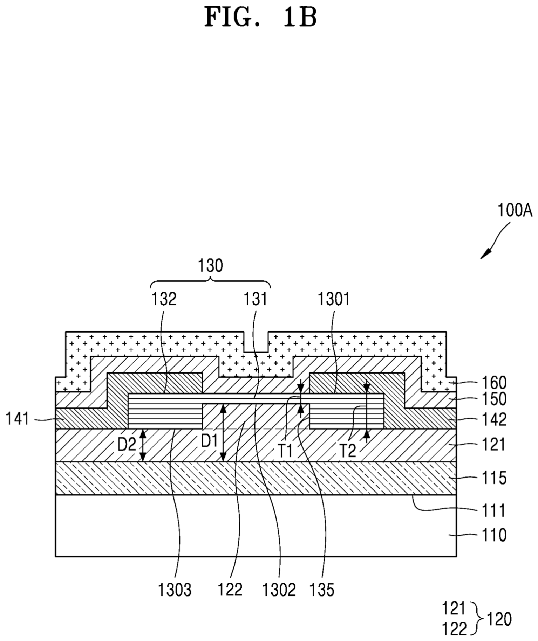

FIG. 1B is a diagram illustrating a case in which a semiconductor device according to an example embodiment has a dual gate structure. In FIG. 1B, the components denoted by the same reference numerals as in FIG. 1A substantially have been described with reference to FIG. 1A, and thus any redundant description is omitted.

A semiconductor device 100A according to an example embodiment may further include a lower gate electrode 115 between the substrate 110 and the patterning layer 120. The patterning layer 120 may include the first patterning layer 121 arranged on the lower gate electrode 115 and the second patterning layer 122 arranged at the trench 135 arranged under the channel area 131. The semiconductor device 100A may be a planar field effect transistor having a dual gate structure including the gate electrode 160 on the channel 130 and the lower gate electrode 115 under the channel 130. In this example embodiment, the patterning layer 120 may pattern a lower structure of the channel 130 and may also function as a gate insulating film for the lower gate electrode 115. Throughout the specification, the patterning layer may also function as a gate insulating film, and hereinafter, any redundant description thereof will be omitted. As such, the semiconductor device 100A may not need a separate process for forming a lower gate insulating film. In the dual gate structure, by increasing the surface of the gate electrode facing the channel 130, the power consumption may be reduced, and the performance of the semiconductor device 100A may be improved.

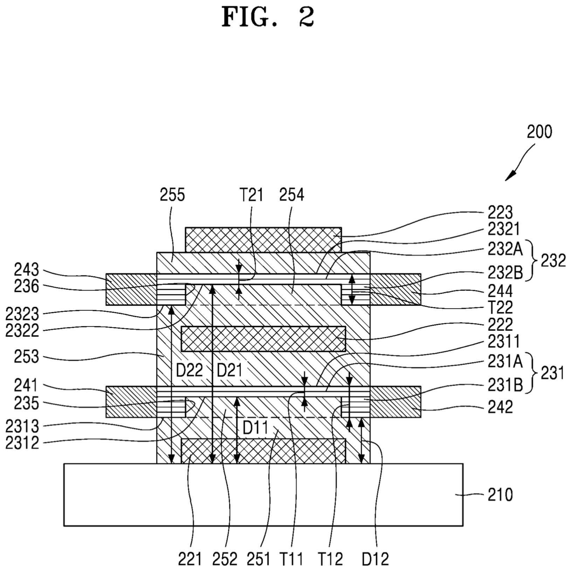

FIG. 2 is a diagram of a semiconductor device according to another example embodiment.

A semiconductor device 200 may include a substrate 210, a first channel 231 arranged apart from the substrate 210, and a second channel 232 arranged apart from the first channel 231.

The first channel 231 may include a 2D material. The first channel 231 may include a first channel area 231A that is relatively thin and a first contact area 231B that is arranged on each of both sides of the first channel area 231A and is relatively thick. The first channel area 231A may include an upper surface 2311 arranged relatively far from the substrate 210, a lower surface 2312 of the first channel area 231A, and a lower surface 2313 of the first contact area 231B. A distance D11 from the lower surface 2312 of the first channel area 231A to an upper surface of the substrate 210 may be greater than a distance D12 from the lower surface 2313 of the first contact area 231B to the upper surface of the substrate 210. A thickness T11 of the first channel area 231A may be less than a thickness T12 of the first contact area 231B. The upper surface 2311 of the first channel 231 may have a plane structure, and the lower surface of the first channel 231 may have a non-plane structure, for example, an intagliated structure. In other words, the upper surface 2311 of the first channel 231 may be a substantially flat plane, and the lower surface of the first channel 231 may be an uneven plane. A first trench 235 may be arranged at a lower portion of the first channel 231.

The second channel 232 may include a 2D material. The second channel 232 may include a second channel area 232A that is relatively thin and a second contact area 232B that is arranged on each of both sides of the second channel area 232A and is relatively thick. The second channel area 232A may include an upper surface 2321 arranged relatively far from the substrate 210, a lower surface 2322 of the second channel area 232A, and a lower surface 2323 of the second contact area 232B. A distance D21 from the lower surface 2322 of the second channel area 232A to an upper surface of the substrate 210 may be greater than a distance D22 from the lower surface 2323 of the second contact area 232B to the upper surface of the substrate 210. A thickness T21 of the second channel area 232A may be less than a thickness T22 of the second contact area 232B. The upper surface 2321 of the second channel 232 may have a plane structure, and the lower surface of the second channel 232 may have a non-plane structure, for example, an intagliated structure. In other words, the upper surface 2321 of the second channel 232 may be a substantially flat plane, and the lower surface of the second channel 232 may be an uneven plane. A second trench 236 may be arranged at a lower portion of the second channel 232.

The second channel 232 may have substantially the same structure as the first channel 231. The material of the second channel 232 may be identical to or different from the material of the first channel 231. For example, the second channel 232 may have a 2D material having a different conductivity type than the first channel 231.

A first gate electrode 221, a first patterning layer 251, and a second patterning layer 252 may be arranged between the substrate 210 and the first channel 231. The second patterning layer 252 may be provided in the first trench 235. As the configuration and the function of the first patterning layer 251 and the second patterning layer 252 are substantially the same as those of the first patterning layer 121 and the second patterning layer 122 described in relation to FIG. 1A, any redundant description thereof is omitted. The first patterning layer 251 and the second patterning layer 252 may also function as a gate insulating film for insulation between the first gate electrode 221 and the first channel 231. A first source electrode 241 and a first drain electrode 242 may be electrically connected to two first contact areas 231B of the first channel 231, respectively.

A second gate electrode 222, a third patterning layer 253 surrounding the second gate electrode 222, and a fourth patterning layer 254 provided in the second trench 236 may be arranged between the first channel 231 and the second channel 232. A second source electrode 243 and a second drain electrode 244 may be electrically connected to two second contact areas 232B of the second channel 232, respectively.

A gate insulating film 255 may be arranged on the second channel 232, and a third gate electrode 223 may be arranged on the gate insulating film 255.

The semiconductor device 200 according to an example embodiment may be applied to a 3D complementary field effect transistor (CFET) structure. The CFET may refer to a structure in which transistors of different conductivity types are stacked vertically. For example, a first FET including the first channel 231 may be an n-type FET, and a second FET including the second channel 232 may be a p-type FET. In other words, the first channel 231 may include an n-type dopant, and the second channel 232 may include a p-type dopant. Or the first FET including the first channel 231 may be a p-type FET, and the second FET including the second channel 232 may be an n-type FET. The first FET may include the first gate electrode 221, the first channel 231, the second gate electrode 222, the first source electrode 241, and the first drain electrode 242. The second FET may include the second gate electrode 222, the second channel 232, the third gate electrode 223, the second source electrode 243, and the second drain electrode 244. The second gate electrode 222 may be shared by both of the first FET and the second FET.

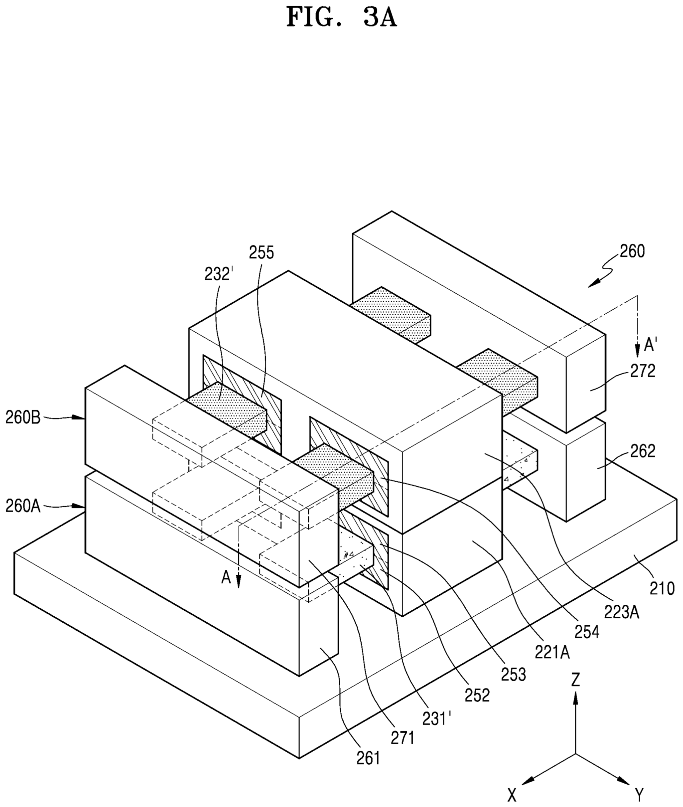

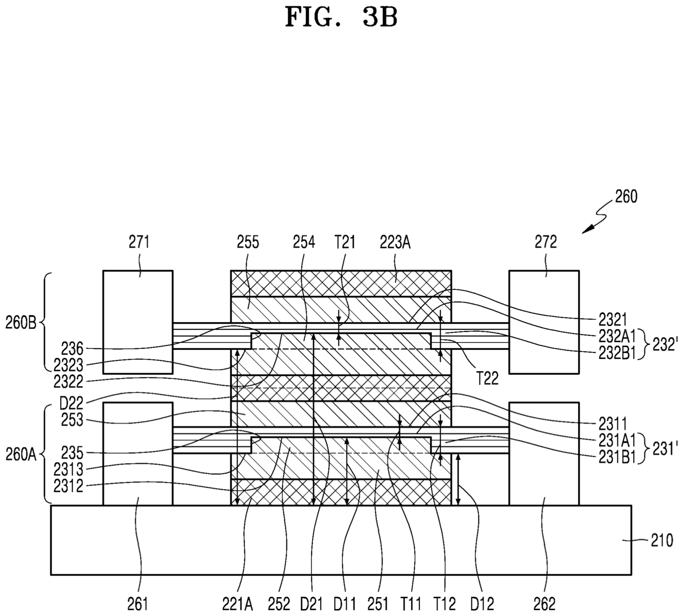

FIG. 3A is a perspective view of a semiconductor device according to another example embodiment, and FIG. 3B is a cross-sectional view taken along line A-A' of FIG. 3A. In FIGS. 3A and 3B, the components denoted by the same reference numerals as in FIG. 2 substantially have been described with reference to FIG. 2, and thus any redundant description is omitted.

Referring to FIGS. 3A and 3B, a semiconductor device 260 may include the substrate 210, a first source electrode 261 and a first drain electrode 262 which are arranged apart from each other on the substrate 210, a second source electrode 271 arranged on the first source electrode 261, and a second drain electrode 272 arranged on the first drain electrode 262. The semiconductor device 260 may include a plurality of first channels 231' electrically connected between the first source electrode 261 and the first drain electrode 262 and a plurality of second channels 232' electrically connected between the second source electrode 271 and the second drain electrode 272. The plurality of first channels 231' may be arranged apart from each other in a first direction (y direction) parallel with the substrate 210. The plurality of second channels 232' may be arranged apart from each other in the first direction (y direction) parallel with the substrate 210.

The plurality of first channels 231' may include a 2D material. The plurality of first channels 231' may include a first channel area 231A1 that is relatively thin and a first contact area 231B1 that is arranged on each of both sides of the first channel area 231A1 and is relatively thick. The first channel area 231A1 may include an upper surface 2311 which is arranged relatively far from the substrate 210, a lower surface 2312 of the first channel area 231A1, and a lower surface 2313 of the first contact area 231B1.

The plurality of second channels 232' may include a 2D material. The plurality of second channels 232' may include a second channel area 232A1 that is relatively thin and a second contact area 232B1 that is arranged on each of both sides of the second channel area 232A1 and is relatively thick. The second channel area 232A1 may include an upper surface 2321 which is arranged relatively far from the substrate 210, a lower surface 2322 of the second channel area 232A1, and a lower surface 2323 of the second contact area 232B1.

The semiconductor device 260 may be applied to a 3D CFET structure. The plurality of second channels 232' may include a 2D material having a different conductivity type from that of the plurality of first channels 231'. For example, a first FET 260A including the plurality of first channels 231' may be an n-type FET, and a second FET 260B including the plurality of second channels 232' may be a p-type FET. In other words, the plurality of first channels 231' may include an n-type dopant, and the plurality of second channels 232' may include a p-type dopant. Alternatively, the first FET 260A including the plurality of first channels 231' may be a p-type FET, and the second FET 260B including the plurality of second channels 232' may be an n-type FET. The first FET 260A may include a first gate electrode 221A, the plurality of first channels 231', the first source electrode 261, and the first drain electrode 262. The second FET 260B may include a second gate electrode 223A, the plurality of second channels 232', the second source electrode 271, and the second drain electrode 272. The first gate electrode 221A may include a material that is identical to or different from that of the second gate electrode 223A. The first gate electrode 221A and the second gate electrode 223A may be electrically connected. Even when another layer is inserted between the first gate electrode 221A and the second gate electrode 223A, the first gate electrode 221A and the second gate electrode 223A may be configured to be electrically connected.

As described above, the semiconductor device (200 or 260) according to the above example embodiments may implement the CFET structure by using the channel including the 2D material.

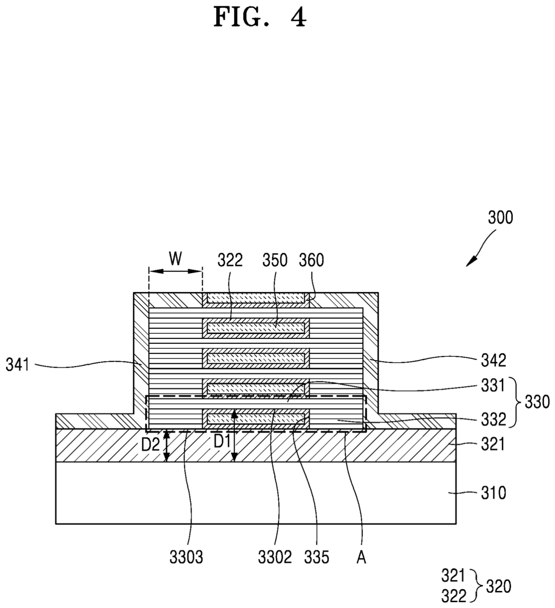

FIG.4 is a schematic cross-sectional view of a semiconductor device according to another example embodiment.

A semiconductor device 300 according to an example embodiment may include a substrate 310, a first patterning layer 321 arranged on the substrate 310, and a plurality of channels 330 arranged on the first patterning layer 321. The plurality of channels 330 may each include a channel area 331 that is relatively thin and a contact area 332 that is relatively thick. A second patterning layer 322 having a closed cross-section may be arranged between the plurality of channel areas 331, and a gate electrode 350 may be provided inside the second patterning layer 322.

The plurality of channels 330 included in the semiconductor device 300 may all be connected. In this example embodiment, as the channels 330 are all connected, the channels 330 may not be particularly partitioned; however, for the sake of convenience, it may be understood that the channel area 331 arranged on the gate electrode 350 and the contact area 332 arranged on a lateral side of the gate electrode 350 constitute one channel and that one channel corresponding to an area denoted by A in the drawings is provided. However, such description is provided only for convenience, and the disclosure is not limited thereto. The plurality of channel areas 331 may be arranged apart from each other, and the plurality of contact areas 332 may be continuously connected to each other to have an integrated structure. In other words, the contact areas 332 on a first side of each of the plurality of channel areas 331 are continuously connected to each other, and the contact area 332 on a second side of each of the plurality of channel areas 331 opposite to the first side are continuously connected to each other. Thus, the semiconductor device 300 may not include a separate space between the channels. The contact area 332 may have a width W greater than a thickness of one layer from among the plurality of 2D material layers included in the channel 330. The contact area 332 may have the width W greater than the thickness of the channel area 331. The width W of the contact area 332 may be, for example, greater than 0 nm and less than or equal to 30 nm. The width W of the contact area 332 may be, for example, about 5 nm to about 30 nm. The contact area 332 may have a structure in which a plurality of two-dimensional material layers are stacked in parallel, and the channel area 331 may have a structure in which a plurality of two-dimensional material layers are stacked in parallel. The stacking direction of the two-dimensional material layers of the contact area 332 and the stacking direction of the two-dimensional material layers of the channel area 331 may be the same. An upper surface of the channel area 331 located at the uppermost position among the plurality of channel areas 331 and an upper surface of the contact area 332 may be located at the same height. That is, the upper surface of the channel area 331 located at the uppermost position among the plurality of channel area 331 and the upper surface of the contact area 332 may form the same surface.

The first patterning layer 321 and the second patterning layer 322 arranged closest to the first patterning layer 321 may be in direct contact with each other. The distance D1 between an upper surface of the substrate 310 and a lower surface 3302 of the channel area 331 may be greater than the distance D2 between the upper surface of the substrate 310 and a lower surface 3303 of the contact area 332. A trench 335 may be provided under the channel area 331 of the lowermost channel 330, and the second patterning layer 322 and the gate electrode 350 may be provided in the trench 335.

A gate insulating film 360 may be arranged on the uppermost channel 330. The gate electrode 350 may be further provided on the gate insulating film 360.

A source electrode 341 and a drain electrode 342 may be arranged on a side wall and an upper portion of the channel area 331. The source electrode 341 and the drain electrode 342 may extend to the upper surface of the first patterning layer 321. In the semiconductor device 300, as a contact surface between the contact area 332 of the channel 330 and the source electrode 341 and the drain electrode 342 is relatively wide, the contact resistance may be reduced, and the on-current may increase. That is, when the contact area 332 is relatively thick, and a contact surface between the lateral surface of the contact area 332 and each of the source electrode 341 and the drain electrode 342 is great, not only the SBH with respect to the electrode may decrease due to reduced bandgap, but also the contact resistance may be reduced due to the increased contact surface in the edge direction.

The plurality of channel areas 331 may have a sheet structure. For example, the plurality of channel areas 331 may have a thickness greater than 0 nm and less than or equal to 10 nm, less than or equal to 5 nm, or less than or equal to 3 nm. The thickness of the channel area 331 may be about 0.7 nm to about 2 nm. The thickness of the channel area 331 is not limited thereto and may be thinner. In this manner, the semiconductor device 300 according to an example embodiment may have a multi-bridge channel structure including a 2D material between the source electrode 341 and the drain electrode 342.

The semiconductor device 300 may include a plurality of vertically stacked channels on the first patterning layer 321. Each of the plurality of vertically stacked channels may include a two-dimensional (2D) material, each of the plurality of vertically stacked channels including a channel area having a relatively thin thickness and a first contact area and a second contact area having relatively thick thicknesses at both sides of the channel area, respectively, each of the plurality of vertically stacked channels 330 including an upper surface and a lower surface closer to the substrate 310 than the upper surface, the lower surface including a first lower surface portion of the channel area 331 and a second lower surface portion of the contact area 332, the second lower surface portion of the contact area 332 of one of the plurality of vertically stacked channels 330 being in direct contact with the upper surface of another one of the plurality of vertically stacked channels 330 that is immediately under the one of the plurality of vertically stacked channels 330. The lower surface may include a first lower surface portion of the channel area 331 and a second lower surface portion of the contact area 332, the second lower surface portion of the contact area 331 of one of the plurality of vertically stacked channels being in direct contact with the upper surface of another one of the plurality of vertically stacked channels 330 that is immediately under the one of the plurality of vertically stacked channels 330.

Next, a method of manufacturing a semiconductor device according to an example embodiment is described.

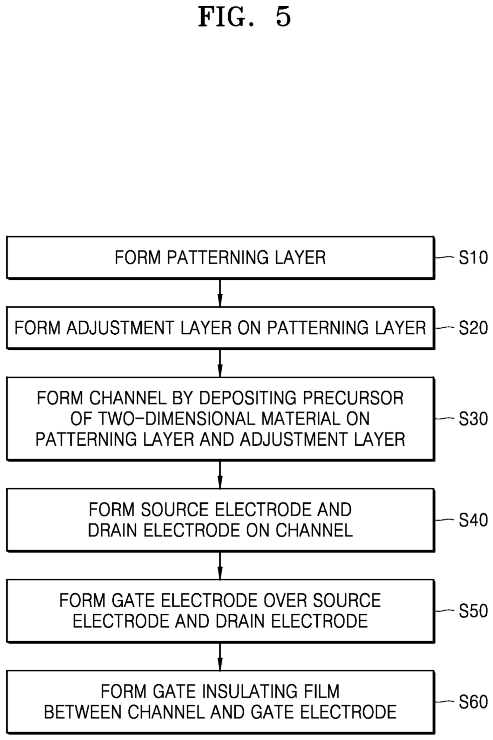

Referring to FIG. 5, the method of manufacturing the semiconductor device include forming a patterning layer in operation S10, forming an adjustment layer on the patterning layer in operation S20, forming a channel by depositing a precursor of a two-dimensional material on the patterning layer and the adjustment layer in operation S30. A source electrode and a drain electrode may be formed on the channel in operation S40. Also, a gate electrode may be formed over the source electrode and the drain electrode in operation S50 and a gate insulating film may be formed between the channel and the gate electrode in operation S60.

The adjustment layer may include a material having a relatively low adsorption capacity with respect to the precursor of the two-dimensional material, compared to the patterning layer. The adjustment layer may include a plurality of adjustment layers having different thicknesses. The method of manufacturing the semiconductor device may further include removing the adjustment layer. The adjustment layer may include a plurality of thicker adjustment layers and a thinner adjustment layer between an adjacent pair of the plurality of thicker adjustment layers. A pocket may be formed between one of the plurality of thicker adjustment layers and the thinner adjustment layer.

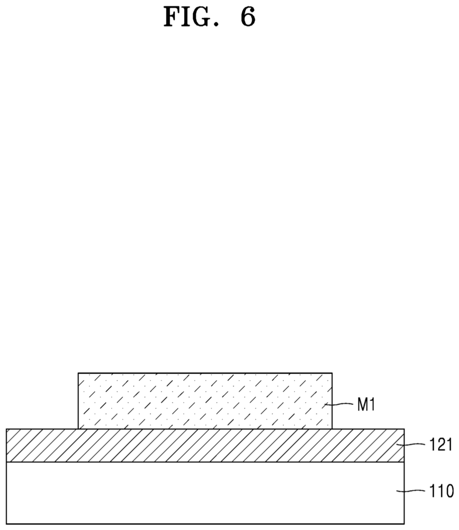

FIGS. 6 to 16 are diagram illustrating a method of manufacturing a semiconductor device according to an example embodiment.

As components in FIG. 6 that are denoted by the same reference numeral as in FIG. 1A have substantially the same configuration and operational effects, detailed descriptions thereon are omitted.

Referring to FIG. 6, the first patterning layer 121 may be deposited on the substrate 110. Then, a first mask M1 may be formed on the first patterning layer 121. The first mask M1 may partially cover the first patterning layer 121.

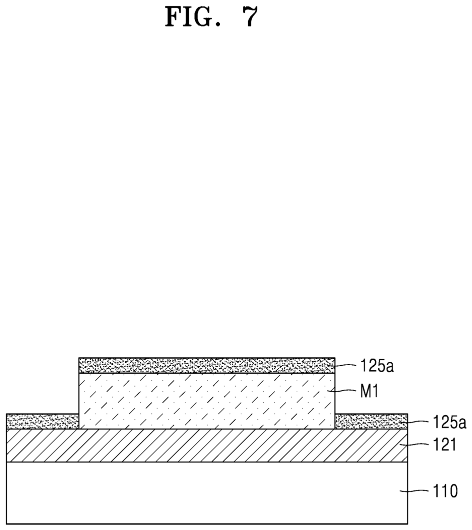

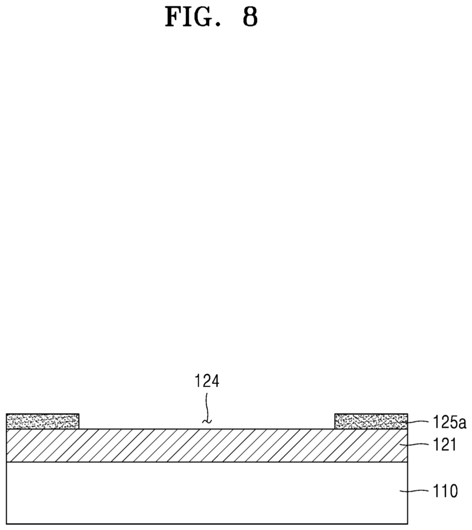

Referring to FIG. 7, a first adjustment layer 125a may be deposited on the first patterning layer 121 and the first mask M1. Referring to FIG. 8, by removing the first mask M1, a first pocket 124 may be formed at the first adjustment layer 125a.

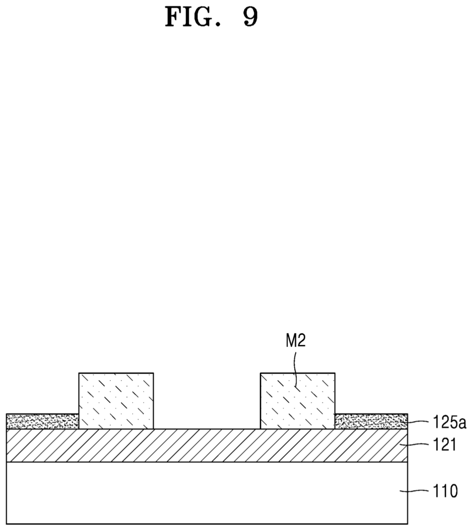

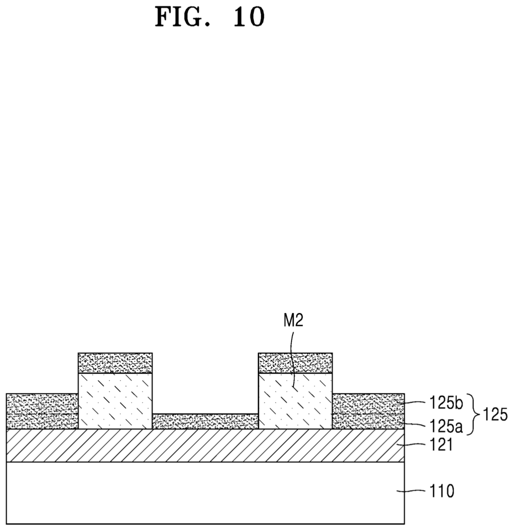

Referring to FIG. 9, two second masks M2 may be arranged apart from each other at the first pocket 124. The two second masks M2 may have a greater thickness than the first adjustment layer 125a. In addition, one surface of each of the two second masks M2 may be in contact with an inner side wall of the first adjustment layer 125a, and a space may be formed between the two second masks M2. Referring to FIG. 10, a second adjustment layer 125b may be deposited on the first adjustment layer 125a and the second masks M2. The first adjustment layer 125a and the second adjustment layer 125b may include the same material and may be included in an adjustment layer 125. The first adjustment layer 125a and the second adjustment layer 125b may include a material having a relatively low adsorption capacity with respect to a precursor of a 2D material, compared to the first patterning layer 121. The first patterning layer 121 may include a high-k material or a ferroelectric material. For example, the first patterning layer 121 may include at least one of HfO₂, HfSiO, HfSiON, HfTaO, HfTiO, HfZrO, HfAlO, ZrO₂, Al₂O₃, or ZrAlO. The adjustment layer 125 may include at least one of SiO₂, Al₂O₃, SiN, or an amorphous carbon layer.

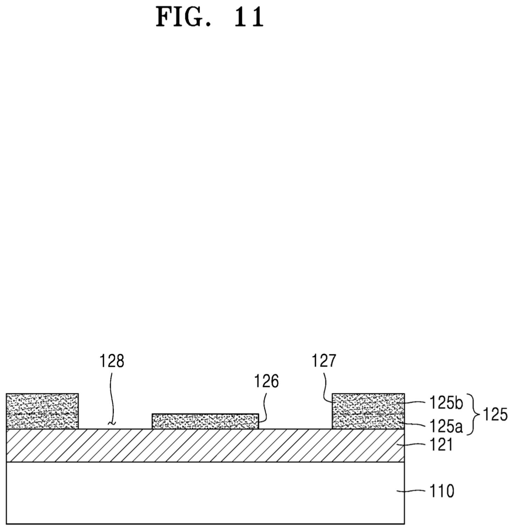

Referring to FIG. 11, by removing the second masks M2, a second pocket 128 may be formed at the adjustment layer 125. The adjustment layer 125 may include a first wall 126 and a second wall 127 arranged apart from the first wall 126. The second pocket 128 may be formed between the first wall 126 and the second wall 127. The thickness of the first wall 126 may be less than the thickness of the second wall 127.

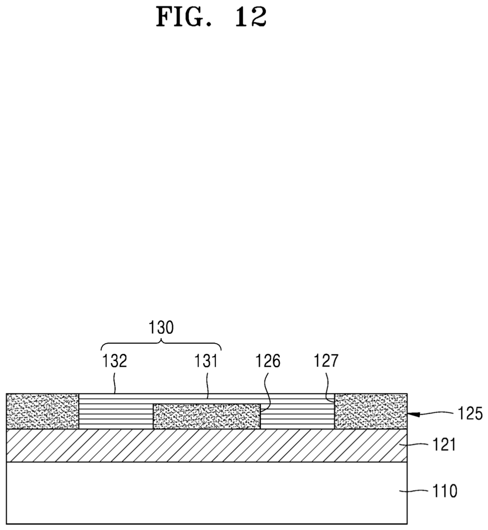

Referring to FIG. 12, the channel 130 may be formed by depositing a 2D material on the first patterning layer 121 and the adjustment layer 125. The 2D material may be deposited by using an atomic layer deposition method. As the first patterning layer 121 includes material having a relatively high surface adsorption capacity with respect to a precursor of a 2D material in comparison with the adjustment layer 125, the 2D material may be selectively deposited on the first patterning layer 121 of the second pocket 128. In addition, after the 2D material is deposited to the height of the first wall 126 of the adjustment layer 125, the 2D material may be deposited on the first wall 126 as well. In this manner, the channel area 131 that is relatively thin may be formed on the first wall 126, and the contact area 132 that is relatively thick may be formed at the second pocket 128.

The precursor of the 2D material may include, for example, a first precursor including at least one of hexacorbonyl having Mo, W, etc. as a core metallic element, oxychloride, or chloride functional group, a second precursor including at least one of S, Se, Te, or a hydrocarbon functional group, or a third precursor including hydrogen chalcogenide such as H₂S, H₂Se, H₂Te, etc. The first precursor may include, for example, at least one of Mo(CO)₆, W(CO)₆, MoO₂Cl₂, WO₂Cl₂, MoCl₅, or WCl₅. The second precursor may include, for example, at least one of di-methyl di-selenide, di-methyl selenide, di-ethyl di-sulfide, di-tert-butyl sulfide, or di-butyl telluride.

In the method of manufacturing a semiconductor device according to an example embodiment, as the channel 130 is formed by depositing a 2D material on the pocket structures which are formed to have different thicknesses from each other according to a combination of the first patterning layer 121 and the adjustment layer 125, the channel 130 may be formed without damage. The second pocket 128 may include a lower surface (e.g., a lower boundary) in contact with the first patterning layer 121 and a side wall (e.g., a side boundary) in contact with the adjustment layer 125. The adjustment layer 125 may be patterned by using a dry etching method or a life-off method to form the second pocket 128. As the second pocket 128 is formed by a combination of the adjustment layer 125 and the first patterning layer 121 which have different surface adsorption capacities with respect to a precursor of a 2D material from each other, the 2D material may be induced to grow at a lower portion of the second pocket 128 by a surface area corresponding to an exposed area of the first patterning layer 121. In addition, the height of the side wall (e.g., the side boundary) of the second pocket 128 may adjust a degree of diffusion of the precursor of the 2D material into the second pocket 128 and may adjust the thickness of the growing 2D material.

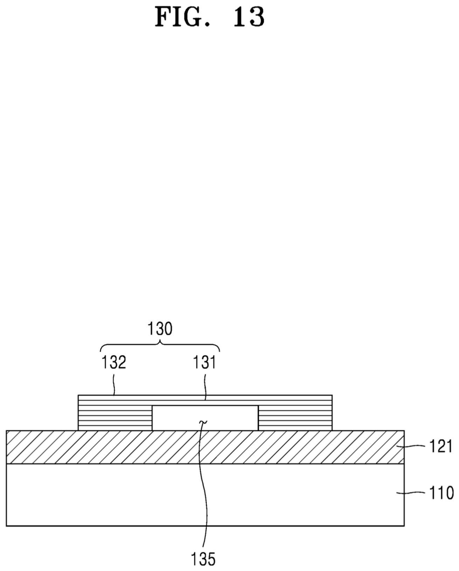

Referring to FIG. 13, the adjustment layer 125 may be removed. By removing the adjustment layer 125, the trench 135 may be formed under the channel area 131 of the channel 130. In this manner, the semiconductor device 100 according to an example embodiment may include a trench 135 having an intagliated shape at a lower portion of the channel 130.

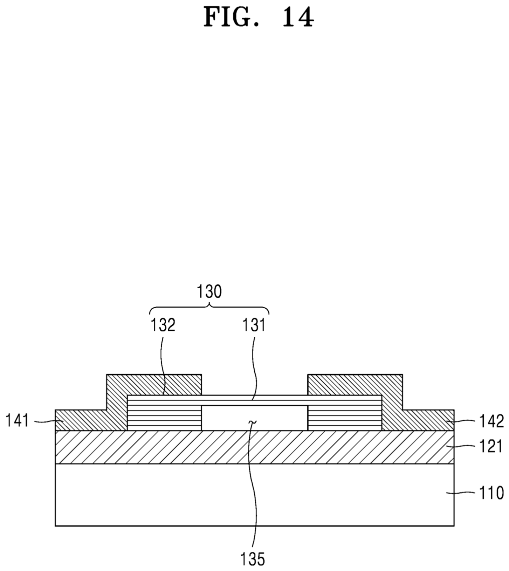

Referring to FIG. 14, by depositing and patterning the electrode on the channel 130, the source electrode 141 and the drain electrode 142 may be formed. The source electrode 141 and the drain electrode 142 may surround the contact area 132. However, the description of the source electrode 141 and the drain electrode 142 is not limited thereto.

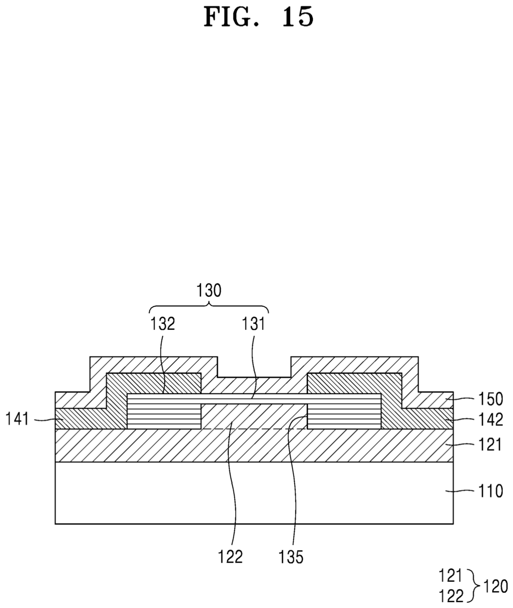

Referring to FIG. 15, the gate insulating film 150 may be deposited on the source electrode 141, the channel 130, and the drain electrode 142. The gate insulating film 150 may be deposited by using a physical vapor deposition method, a chemical vapor deposition method, or an atomic layer deposition method. The gate insulating film 150 may include a high-k material or a ferroelectric material. The high-k material or the ferroelectric material may be deposited on the trench 135 as well. A layer deposited on the trench 135 may be referred to as the second patterning layer 122. As the trench 135 is formed for patterning of the lower structure of the channel 130, the layer formed at the trench 135 is referred to as the second patterning layer 122, and the patterning layer 120 may include the first patterning layer 121 and the second patterning layer 122. In the manufacturing process, the gate insulating film 150 and the second patterning layer 122 may include the same material. Depending on a structure, the first patterning layer 121 and the second patterning layer 122 may also function as a gate insulating film. The first patterning layer 121 and the second patterning layer 122 may include the same material. However, when desired, the first patterning layer 121 and the second patterning layer 122 may include different materials from each other.

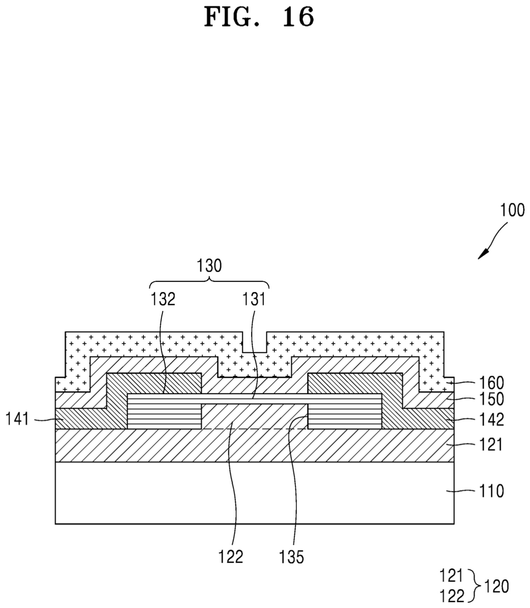

Referring to FIG. 16, the gate electrode 160 may be formed on the gate insulating film 150. The gate electrode 160 may be formed by using a chemical vapor deposition method, a physical vapor deposition method, or an atomic layer deposition method.

In this manner, the semiconductor device 100 including a 2D material channel which has structures (e.g., portions) having different thickness from each other may be manufactured. The method of manufacturing a semiconductor device according to an example embodiment may provide a method of growing a wafer-scale thin film in which a growth thickness of a 2D material is adjustable.

Hereinafter, a method of manufacturing a semiconductor device according to an example embodiment and a manufacturing method of the comparative example are compared and described.

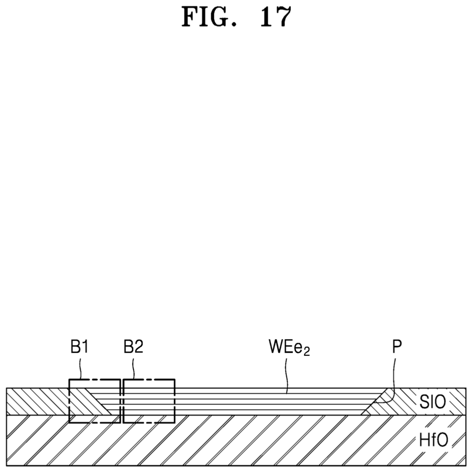

FIG. 17 illustrates a case in which after a SiO adjustment layer is deposited on a HfO patterning layer, a pocket structure P is formed in the SiO adjustment layer, and a WSe₂ layer, which is as 2D material is deposited on the packet structure P. To deposit the 2D material, two material layers having different surface adsorption capacities with respect to a precursor of the 2D material may be used. A material layer having a relatively high surface adsorption capacity of a precursor of the 2D material may be arranged under a material layer having a relatively low surface adsorption capacity of a precursor of the 2D material. Then, the pocket structure P for depositing the 2D material on the material layer having a relatively high surface adsorption capacity of a precursor of the 2D material may be formed. For example, the HfO patterning layer may have a relatively high surface adsorption capacity with respect to a precursor of a 2D material than the SiO adjustment layer. As the SiO adjustment layer has a relatively low surface adsorption capacity with respect to a precursor of the 2D material than the HfO patterning layer, the WSe₂ layer may be sequentially deposited on the HfO patterning layer of the pocket structure P.

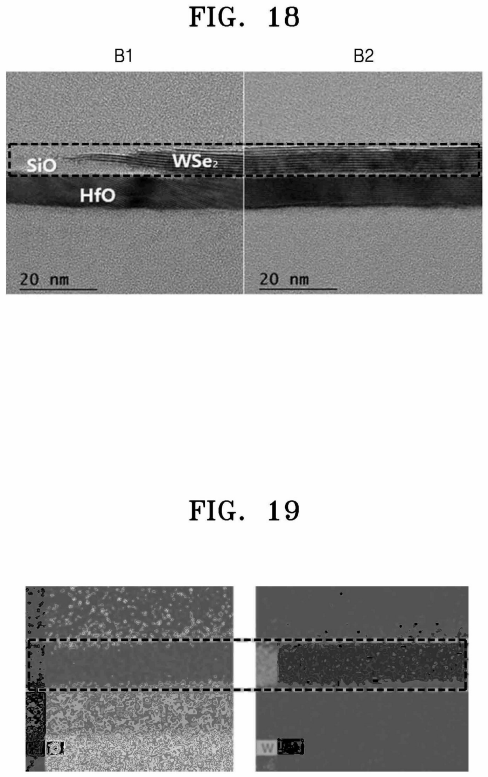

FIG. 18 is a transmission electron microscope (TEM) analysis image of images B1 and B2 of FIG. 17 and shows that the WSe₂ layer is deposited on the pocket structure P and is not deposited on the SiO adjustment layer. FIG. 19 shows energy dispersive X-ray spectroscopy (EDX) analysis results in which Hf and O, and W and Se were respectively analyzed. Referring to FIGS. 18 and 19, the 2D material layer may be deposited without damage by using two material layers having different surface adsorption capacities with respect to a precursor of the 2D material.

FIG. 19 shows component analysis of areas B1 and B2 by using an EDX analysis method. According to the analysis results, a HfO component, W, and a Se component were analyzed. As such, the 2D material channel may be deposited according to a shape of the pocket structure P by using two material layers having different surface adsorption capacities with respect to a precursor of the 2D material. As the 2D material is deposited on the pocket structure P without using an etching process, the channel may be formed without damage.

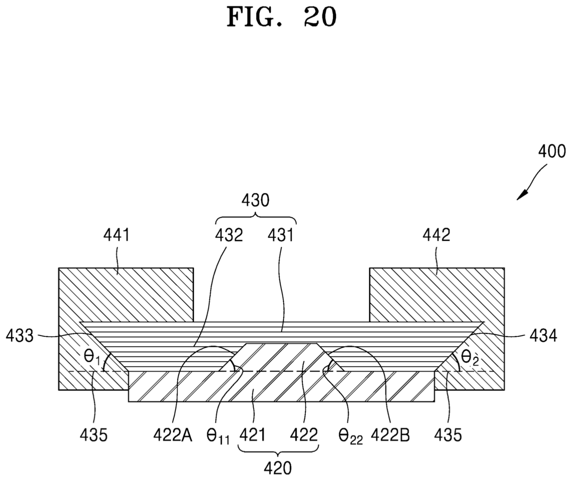

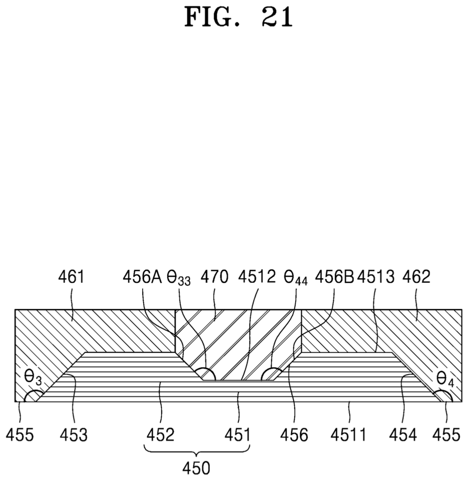

FIG. 20 illustrates a semiconductor device manufactured according to a manufacturing method of a semiconductor device according to an example embodiment, and FIG. 21 illustrates a semiconductor device manufactured according to a manufacturing method of a semiconductor device according to a comparative example.

Referring to FIG. 20, a semiconductor device 400 according to an example embodiment may include a patterning layer 420, a channel 430 arranged on the patterning layer 420, and a source electrode 441 and a drain electrode 442 that are arranged on both sides of the channel 430, respectively. The patterning layer 420 may include a first patterning layer 421 and a second patterning layer 422 arranged on the first patterning layer 421. The channel 430 may include a channel area 431 that is relatively thin and a contact area 432 that is relatively thick. The channel area 431 may be arranged on the second patterning layer 422, and the contact area 432 may be arranged on the first patterning layer 421. The channel 430 may be formed according to a second pocket 128 defined by an adjustment layer (e.g., adjustment layer 125 of FIG. 12) in the manufacturing process. Although FIG. 12 illustrates that a side wall (e.g., a side boundary) of the pocket 128 and the substrate 110 form a right angle, the pocket 128 of the adjustment layer 125 may be formed by, for example, a dry etching process, and the width of the pocket 128 may decrease from the top to the bottom. Accordingly, in the dry etching process, the side wall (e.g., a side boundary) of the pocket 128 may have a tilted (e.g., inclined or slanted) shape. As the channel 430 is deposited according to a shape of the pocket 128, a side wall 433 of the contact area 432 of the channel 430 may have a tilted structure as illustrated in FIG. 20. At least one of an angle θ1 between the side wall 433 and an extension line 435 of the lower surface of the contact area 432 or an angle θ2 between a side wall 434 and the extension line 435 of the lower surface of the contact area 432 may be greater than 0° and less than 90°. Side walls 422A and 422B of the second patterning layer 422 may have a tilted structure. At least one of an angle θ₁₁ between the side wall 422A or the extension line 435 and an angle θ₂₂ between the side wall 422B and the extension line 435 may be greater than 0° and less than 90°.

FIG. 21 illustrates a comparative example, and in the comparative example, after a 2D material channel 450 is deposited on a substrate (not shown), by etching the 2D material channel 450, a channel area 451 that is relatively thin and a contact area 452 that is relatively thick may be formed. A trench 456 may be formed in an upper portion of the channel area 451. The trench 456 may include tilted side walls 456A and 456B. A gate insulating film 470 may be formed on the channel area 451, and a source electrode 461 and a drain electrode 462 may be formed on the contact area 452.

In the comparative example, as a channel 450 is etched by an etching process, a surface of the channel area 451 may be damaged. The channel 450 may include a lower surface 4511, an upper surface 4512 of the channel area 451, and an upper surface 4513 of the contact area 452. The lower surface 4511 of the channel 450 may have a plane structure, and the upper surfaces 4512 and 4513 of the channel 450 may have a non-plane structure. In other words, the lower surface 4511 of the channel 450 may be a substantially flat plane, and the upper surfaces 4512 and 4513 of the channel 450 may have an uneven plane.

In the comparative example, as the 2D material channel 450 is etched from the top, side walls 453 and 454 of the channel 450 may be formed in a tilted manner. An angle θ3 between the side wall 453 and an extension line 455 of the lower surface 4511 of the channel 450 and an angle θ4 between the side wall 454 and the extension line 455 of the lower surface 4511 of the channel 450 may be greater than 90° and less than 180°. An angle θ₃₃ between the side wall 456A of the trench 456 and the upper surface 4512 of the channel area 451 and an angle θ₄₄ between the side wall 456B and the upper surface 4512 of the channel are 451 may be greater than 0° and less than 180°.

Next, a method of manufacturing the semiconductor device 300 illustrated in FIG. 4 is described.

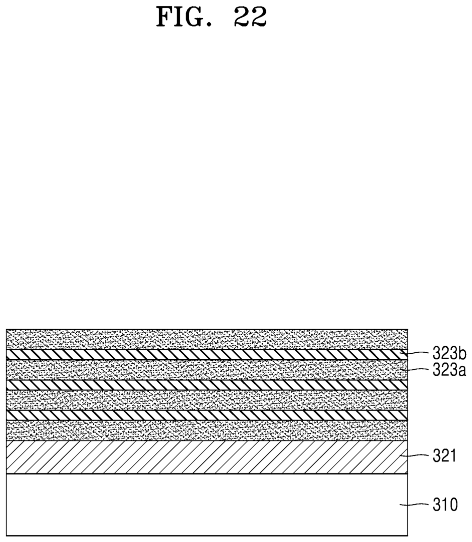

Referring to FIG. 22, the first patterning layer 321 may be deposited on the substrate 310, and a first adjustment layer 323a and a sacrificial layer 323b may be alternately stacked multiple times on the first patterning layer 321. The first patterning layer 321 may include a high-k material or a ferroelectric material, and the first adjustment layer 323a may include at least one of SiO₂, Al₂O₃, SiN, or an amorphous carbon layer. The sacrificial layer 323b may include a material which may be selectively removed by a wet etchant or a dry etchant.

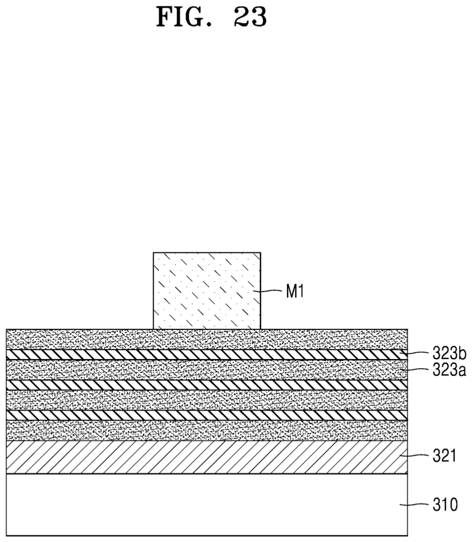

Referring to FIG. 23, the first mask M1 may be formed on the uppermost first adjustment layer 323a. The first mask M1 may be formed to partially cover the first adjustment layer 323a.

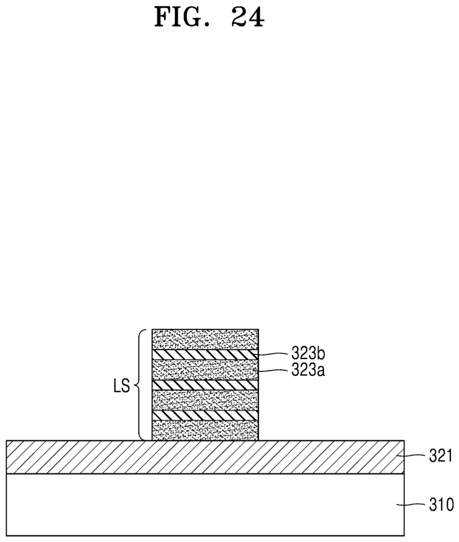

Referring to FIG. 24, by using the first mask M1, the first adjustment layer 323a and the sacrificial layer 323b which are located where the first mask M1 is not formed may be removed. In this manner, a stacked structure LS of the first adjustment layer 323a and the sacrificial layer 323b, which is patterned to have a limited width by the first mask M1 may be formed. Then, the first mask M1 may be removed.

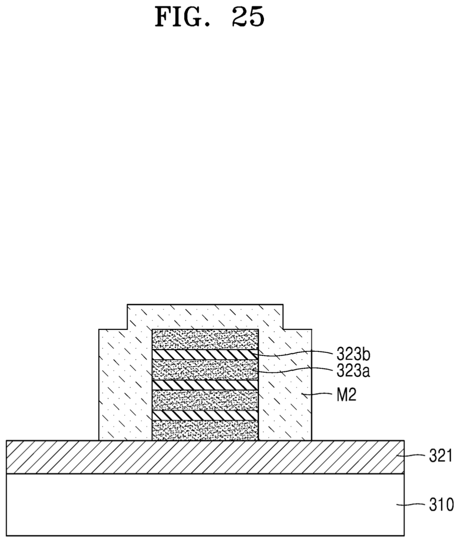

Referring to FIG. 25, the second mask M2 covering the stacked structure LS may be formed.

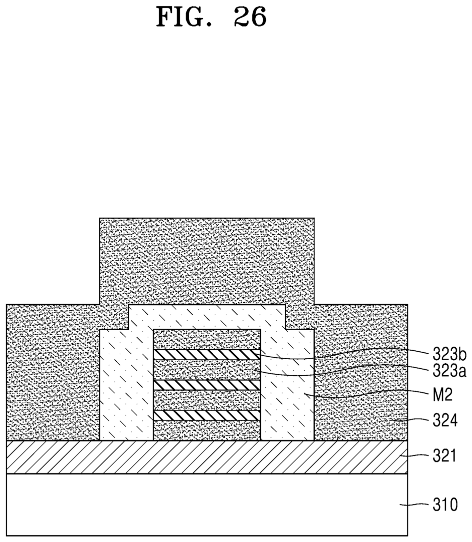

Referring to FIG. 26, a second adjustment layer 324 may be formed on the first patterning layer 321 and the second mask M2. The second adjustment layer 324 and the first adjustment layer 323a may include the same material.

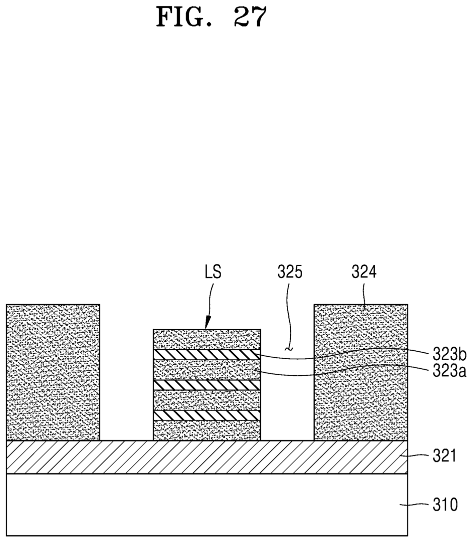

Referring to FIG. 27, the second adjustment layer 324 on the second mask M2 and the second mask M2 may be removed. By removing the second mask M2, a pocket 325 may be formed between the stacked structure LS and the second adjustment layer 324. The height of the second adjustment layer 324 may be greater than the height of the stacked structure LS.

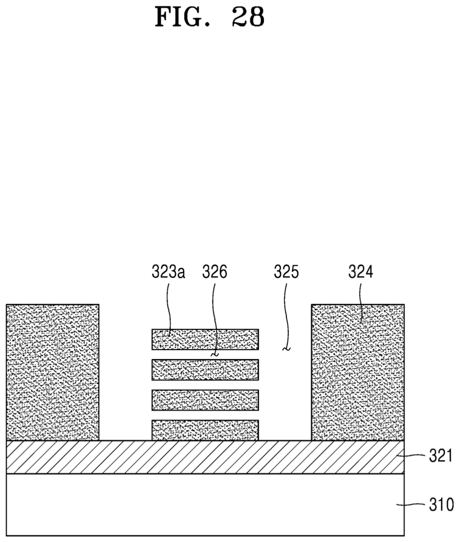

Referring to FIG. 28, the sacrificial layer 323b may be removed. A space 326 between the first adjustment layers 323a may be formed where the sacrificial layer 323b is removed.

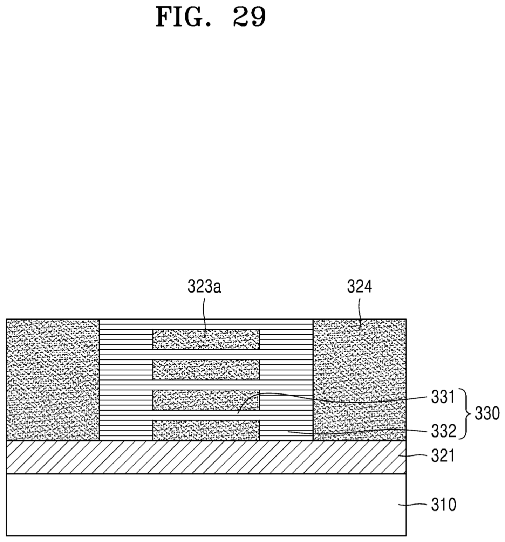

Referring to FIG. 29, by depositing a 2D material on the pocket 325 and the space 326, the channel 330 may be formed. The channel 330 may include a plurality of channel areas 331 formed apart from each other in the space 326 and the contact area 332 formed in the pocket 325. As the first patterning layer 321 includes a material having a relatively high surface adsorption capacity with respect to a precursor of a 2D material than the first adjustment layer 323a and the second adjustment layer 324, the 2D material may be deposited sequentially from the first patterning layer 321 towards the upper portion. In this manner, a plurality of channel areas 331 that are relatively thin may be formed in a multi-bridge structure. The contact area 332 may have a 3D structure which is formed continuously on both sides of the plurality of channel areas 331 and thus has a thick thickness.

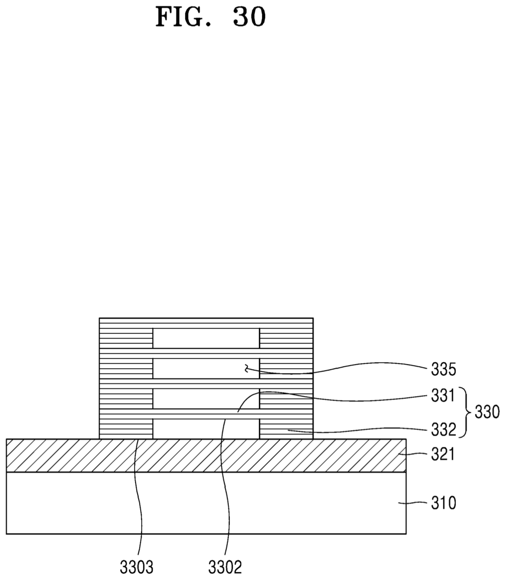

Referring to FIG. 30, the first adjustment layer 323a and the second adjustment layer 324 may be removed. The trench 335 may be formed where the first adjustment layer 323a is removed.

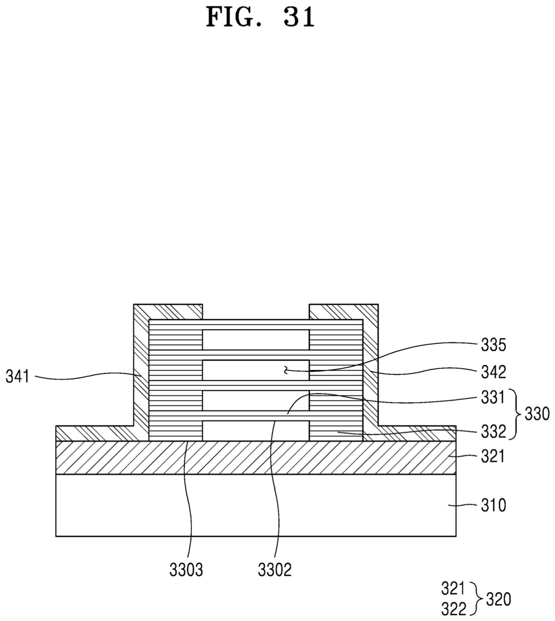

Referring to FIG. 31, the source electrode 341 and the drain electrode 342 may be formed on the contact area 332 and the first patterning layer 321.

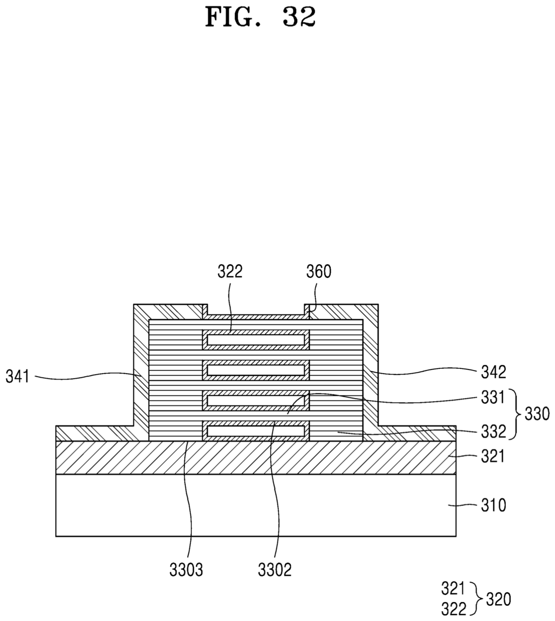

Referring to FIG. 32, the second patterning layer 322 may be formed in the trench 335, and the gate insulating film 360 may be formed on the uppermost channel area 331. The second patterning layer 322 and the gate insulating film 360 may include the same material and may be formed in the same process. The second patterning layer 322 may also function as a gate insulating film.

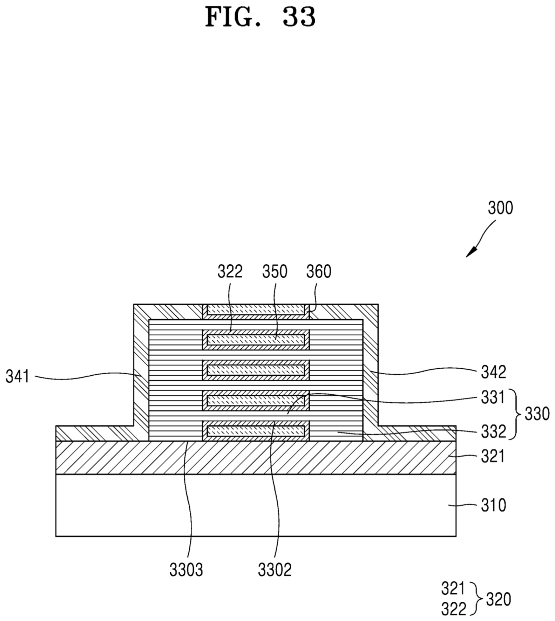

Referring to FIG. 33, the gate electrode 350 may be formed on and/or the second patterning layer 322 and on the gate insulating film 360. The gate electrode 350 may surround the second patterning layer 322 and the gate insulating film 360. In this manner, a gate all-around structure in which the gate electrode 350 surrounds the channel area 331 may be formed. Then, the semiconductor device 300 having a multi-bridge structure in which the plurality of channel areas 331 that are relatively thin are arranged apart from each other in a direction perpendicular to the substrate 310, and the contact areas 332 which are relatively thick are continuously formed may be formed.

As described above, in the method of manufacturing a semiconductor device according to an example embodiment, by using an adjustment layer and a patterning layer which have different surface adsorption capacity with respect to a precursor of a 2D material, a channel including a channel area and a contact area which have different thicknesses from each other may be formed through a selective deposition method.

In addition, as the semiconductor device according to an example embodiment includes a channel including a 2D material, and the channel includes a channel area that is relatively thin and a contact area that is relatively thick, a relatively high on/off ratio may be maintained, and the semiconductor device may have relatively low contact resistance and/or relatively high on-current.

As a semiconductor device according to an example embodiment is micro-sized and has an improved electrical performance, it may be applied to an integrated circuit device having a relatively high degree of integration. The semiconductor device according to an example embodiment may be applied to a logic device, a memory device, a display device, etc.

The semiconductor device according to an example embodiment may be included in a transistor constituting a digital circuit or an analog circuit. In some example embodiments, a semiconductor device may be used as a high-voltage transistor or a low-voltage transistor. For example, the semiconductor device according to an example embodiment may be included in a relatively high-voltage transistor constituting a peripheral circuit of a flash memory device or an electrically erasable and programmable read-only memory (EEPROM) device, which are a nonvolatile memory device operating at a relatively high voltage. The semiconductor device according to an example embodiment may be included in a transistor included in an integrated circuit (IC) apparatus for liquid crystal display which desires an operating voltage of 10 V or higher, e.g., about 20 V to about 30 V or an IC chip used in a plasma display panel (PDP) which desires an operating voltage of 100 V.

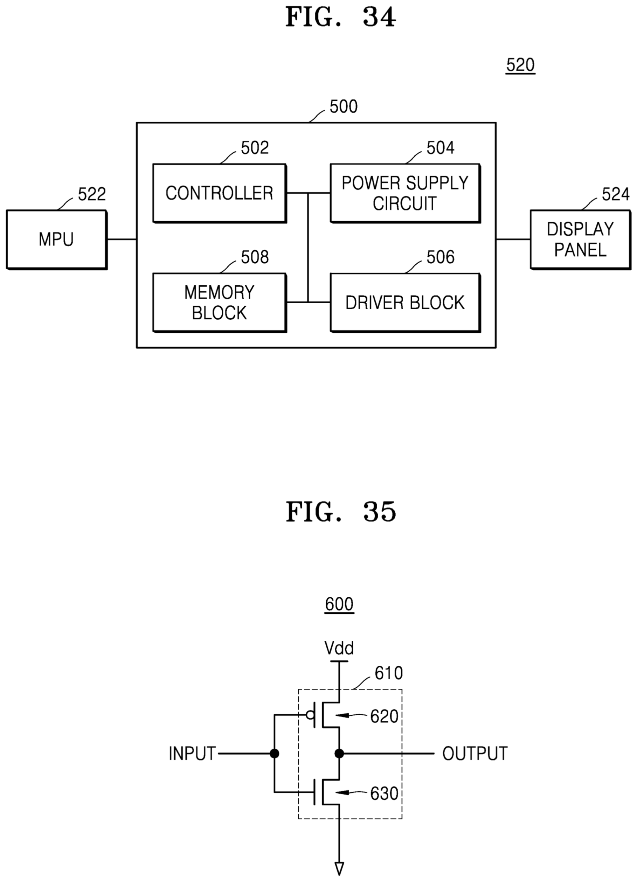

FIG. 34 is a schematic block diagram of a display apparatus 520 including a display driver IC (DDI) 500 according to an example embodiment.

Referring to FIG. 34, the DDI 500 may include a controller 502, a power supply circuit 504, a driver block 506, and a memory block 508. The controller 502 may receive and decode a command applied from a main processing unit (MPU) 522 and control each block of the DDI 500 to implement an operation according to the command. The power supply circuit 504 may generate a driving voltage in response to the control by the controller 502. The driver block 506 may drive a display panel 524 by using the driving voltage generated by the power supply circuit 504 in response to the control by the controller 502. The display panel 524 may be a liquid crystal display panel or a plasma display panel. The memory block 508 may temporarily store a command input to the controller 502, control signals output from the controller 502, or necessary data, and may include a memory such as RAM, ROM, etc. The power supply circuit 504 and the driver block 506 may include the semiconductor device according to an example embodiment.

FIG. 35 is a circuit diagram of a complementary metal-oxide semiconductor (CMOS) inverter 600 according to an example embodiment.

The CMOS inverter 600 may include a CMOS transistor 610. The CMOS transistor 610 may include a p-channel metal oxide semiconductor (PMOS) transistor 620 and an n-channel metal oxide semiconductor (NMOS) transistor 630 which are connected between a power terminal Vdd and a ground terminal. The CMOS transistor 610 may include the semiconductor device according to an example embodiment.

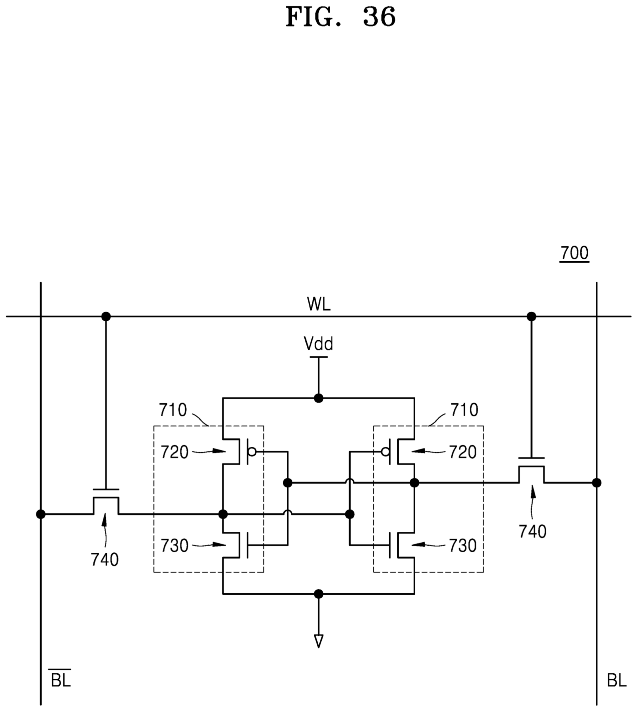

FIG. 36 is a circuit diagram of a CMOS static random-access memory (SRAM) device 700 according to an example embodiment.

The CMOS SRAM device 700 may include a pair of driver transistors 710. The pair of driver transistors 710 may each include a PMOS transistor 720 and an NMOS transistor 730 connected between a power terminal Vdd and a ground terminal. The CMOS SRAM device 700 may further include a pair of transmission transistors 740. A source of the transmission transistor 740 may be cross-connected to a common node of the PMOS transistor 720 and the NMOS transistor 730 constituting the driver transistor 710. The power terminal Vdd may be connected to the source of the PMOS transistor 720, and the ground terminal may be connected to the source of the NMOS transistor 730. A word line WL may be connected to the gate of the pair of the transmission transistors 740, and a bit line BL and an inverted bit line may be connected to drains of each of the pair of transmission transistors 740, respectively.

At least one of the driver transistors 710 and/or at least one of the transmission transistors 740 of the CMOS SRAM device 700 may include the semiconductor device according to an example embodiment.

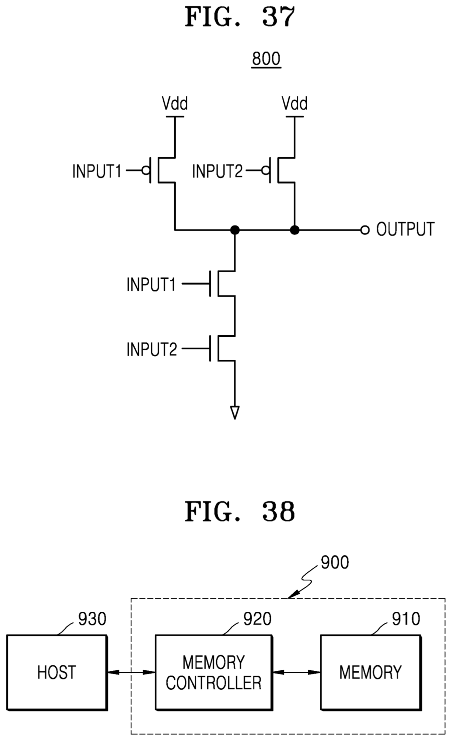

FIG. 37 is a circuit diagram of a CMOS NAND circuit 800 according to an example embodiment.

The CMOS NAND circuit 800 may include a pair of CMOS transistors which receive different input signals from each other. The CMOS NAND circuit 800 may include the semiconductor device according to an example embodiment.

FIG. 38 is a block diagram of an electronic apparatus 900 according to an example embodiment.

The electronic apparatus 900 may include a memory 910 and a memory controller 920. The memory controller 920 may control the memory 910 to read data from the memory 910 and/or write data on the memory 910 in response to a request from a host 930. At least one of the memory 910 or the memory controller 920 may include the semiconductor device according to an example embodiment.

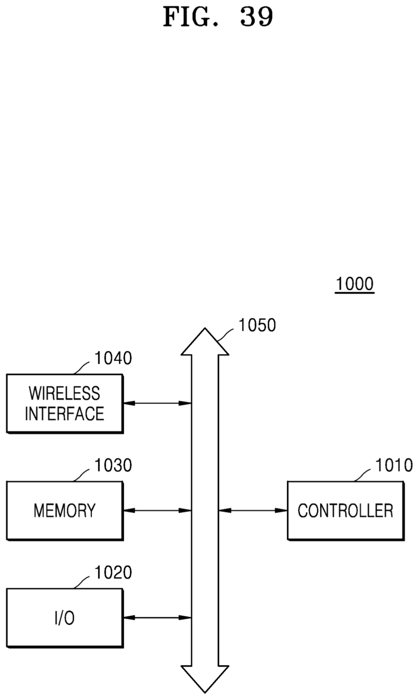

FIG. 39 is a block diagram of an electronic apparatus 1000 according to an example embodiment.

The electronic apparatus 1000 may constitute a wireless communication apparatus or an apparatus configured to transmit and/or receive information under a wireless environment. The electronic apparatus 1000 may include a controller 1010, an input/output apparatus (I/O) 1020, a memory 1030, and a wireless interface 1040, which are connected to each other through a bus 1050.

The controller 1010 may include at least one of a microprocessor, a digital signal processor, or any other similar processors. The I/O 1020 may include at least one of a keypad, a keyboard, or a display. The memory 1030 may be used to store commands performed by the controller 1010. For example, the memory 1030 may be used to store user data. The electronic apparatus 1000 may use the wireless interface 1040 to transmit/receive data through a wireless communication network. The wireless interface 1040 may include an antenna and/or a wireless transceiver. In some example embodiments, the electronic apparatus 1000 may be used to a communication interface protocol of a 3rd generation communication system, for example, code division multiple access (CDMA), global system for mobile communications (GSM), north American digital cellular (NADC), extended-time division multiple access (E-TDMA), and/or wide band code division multiple access (WCDMA). The electronic apparatus 1000 may include the semiconductor device according to an example embodiment.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

As the semiconductor device according to an example embodiment has an improved electrical performance due to its micro-sized structure, the semiconductor device may be applied to an integrated circuit device and have characteristics of miniaturization, relatively low power consumption, and/or relatively high performance.

A semiconductor device according to an example embodiment includes a substrate, a patterning layer on the substrate, a channel on the patterning layer and including a 2D material, a source electrode and a drain electrode electrically connected to the channel, a gate electrode on or arranged apart from the channel, and a gate insulating film between the channel and the gate electrode, wherein the channel may include a channel area having a relatively thin thickness and a contact area having a relatively thick thickness, the channel may include an upper surface and a lower surface, the upper surface of the channel being farther from the substrate than the lower surface of the channel, the lower surface of the channel including a lower surface of the channel area and a lower surface of the contact area, and a first distance from the lower surface of the channel area to an upper surface of the substrate may be greater than a second distance from the lower surface of the contact area to the upper surface of the substrate.

The upper surface of the channel may have a plane structure. In other words, the upper surface of the channel may be a substantially flat plane.

The channel may have a structure in which a plurality of 2D material layers are stacked, and the number of the 2D material layers of the channel area may be less than the number of the 2D material layers of the contact area.

The number of the layers of the contact area may be 5 to 20.

The channel may include at least one of a transition metal dichalcogenide (TMD) material, graphene, black phosphorus, amorphous boron nitride, or phosphorene.

The patterning layer may include a high-k material or a ferroelectric material.

The patterning layer may include a first patterning layer on the substrate and a second patterning layer under the channel area.

A lower gate electrode may be further between the substrate and the patterning layer.

The channel may include a plurality of channel areas arranged apart from each other in a direction away from substrate.

The contact areas arranged on both sides of each of the plurality of channel areas may be continuously connected to each other. In other words, the contact area on a first side of each of the plurality of channel areas are continuously connected to each other, and the contact area on a second side of each of the plurality of channel areas opposite to the first side are continuously connected to each other.

Another patterning layer, another channel, another gate insulating film, and another gate electrode may be further arranged on the gate electrode, and the another channel may include a material having a different conductivity type than that of a material of the channel.

A method of manufacturing a semiconductor device according to an example embodiment includes forming a first patterning layer on a substrate, forming on the first patterning layer an adjustment layer including a first wall having a first thickness and a second wall arranged on and apart from both sides of the first wall and having a second thickness greater than the first thickness by using a mask, forming a channel including a channel area formed on the first wall and a contact area formed between the first wall and the second wall by depositing a 2D material on the adjustment layer, removing the adjustment layer; forming a source electrode and a drain electrode on the contact area of the channel, forming a gate insulating film on the source electrode, the drain electrode, and the channel, and forming a gate electrode on the gate insulating film.

A pocket may be formed between the first wall and the second wall, and the first patterning layer may be exposed in the pocket.

The first patterning layer may include a high-k material or a ferroelectric material.

The adjustment layer may include at least one of SiO₂, Al₂O₃, SiN, or an amorphous carbon layer.

The channel may include an upper surface and a lower surface, the upper surface of the channel being farther from the substrate than the lower surface of the channel, the lower surface of the channel including a lower surface of the channel area and a lower surface of the contact area, and a first distance from the lower surface of the channel area to an upper surface of the substrate may be greater than a second distance from the lower surface of the contact area to the upper surface of the substrate.

A method of manufacturing a semiconductor device according to an example embodiment includes forming a first patterning layer on a substrate, forming a first adjustment layer and a sacrificial layer alternately on the first patterning layer, patterning a stacked structure of the first adjustment layer and the sacrificial layer by using a first mask, forming a second mask on the stacked structure, forming a second adjustment layer on and apart from both sides of the stacked layer by using the second mask, removing the sacrificial layer from the stacked structure, forming a channel including a plurality of channel areas formed to be apart from each other in a space from which the sacrificial area is removed and a contact area formed between the stacked structure and the second adjustment layer by depositing a 2D material in the space from which the sacrificial area is removed and between the stacked structure and the second adjustment layer, removing the first adjustment layer and the second adjustment layer, forming a source electrode and a drain electrode on the contact area, forming a second patterning layer and a gate insulating film in the plurality of channel areas, and forming a gate electrode in the second patterning layer and the gate insulating film.

The first adjustment layer and the second adjustment layer may include at least one of SiO₂, Al₂O₃, SiN, or an amorphous carbon layer.

A first height of the second adjustment layer may be greater than a second height of the stacked structure.

An electronic apparatus according to an example embodiment includes a memory including a semiconductor device and a memory controller.

The semiconductor device includes a substrate, a patterning layer on the substrate, a channel on the patterning layer and including a 2D material, a source electrode and a drain electrode electrically connected to the channel, a gate electrode on the channel, and a gate insulating film between the channel and the gate electrode, wherein the channel may include a channel area having a relatively thin thickness and a contact area having a relatively thick thickness, the channel may include an upper surface and a lower surface, the upper surface of the channel being farther from the substrate than the lower surface of the channel, the lower surface of the channel including a lower surface of the channel area and a lower surface of the contact area, and a first distance from the lower surface of the channel area to an upper surface of the substrate may be greater than a second distance from the lower surface of the contact area to the upper surface of the substrate.

As the semiconductor device according to an example embodiment includes a channel including a 2D material, and the channel includes a channel area that is relatively thin and a contact area that is relatively thick, the semiconductor device may have a relatively high on/off ratio and/or relatively low contact resistance.

In the method of manufacturing a semiconductor device according to an example embodiment, a pocket which has structures having different depths from each other may be formed by using two materials having different surface adsorption capacity for a precursor of a 2D material, and a 2D material may be deposited in the pocket. In this manner, channels having different thicknesses from each other may be formed without performing an etching process on the 2D material layers.

A semiconductor device according to an example embodiment may include a patterning layer including a first patterning portion and a second patterning portion on a central position of the first patterning portion, the second patterning portion being narrower than the first patterning portion in a horizontal direction, a channel on the patterning layer and including a two-dimensional (2D) material, and a source electrode and a drain electrode on both sides of the channel, respectively, and electrically connected to the channel.

The channel may include a channel area on the second patterning portion and a contact area on the first patterning portion, the channel area being thinner than the contact area in a vertical direction.

At least one of a first angle between a first side wall of the second patterning portion and a horizontal extension line of a lower surface of the contact area or a second angle between a second side wall of the second patterning portion and the horizontal extension line of the lower surface of the contact area may be greater than 0° and less than 90°.

A third side wall and a fourth side wall of the second patterning portion that may be opposite to each other, and each of the third side wall and the fourth side wall may have a tilted structure such that at least one of a third angle between the third side wall of the second patterning portion and the horizontal extension line of the lower surface of the contact area or a fourth angle between the fourth side wall of the second patterning portion and the horizontal extension line of the lower surface of the contact area may be greater than 0° and less than 90°.

It should be understood that some example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A semiconductor device comprising:
a substrate;
a patterning layer on the substrate;
a channel on the patterning layer and including a two-dimensional, 2D, material;
a source electrode and a drain electrode electrically connected to the channel;
a gate electrode on the channel; and
a gate insulating film between the channel and the gate electrode,
wherein the channel includes a channel area having a relatively thin thickness and a contact area having a relatively thick thickness,
the channel includes an upper surface and a lower surface, the upper surface of the channel being farther from the substrate than the lower surface of the channel, the lower surface of the channel including a lower surface of the channel area and a lower surface of the contact area, and
a first distance from the lower surface of the channel area to an upper surface of the substrate is greater than a second distance from the lower surface of the contact area to the upper surface of the substrate.

2. The semiconductor device of claim 1, wherein the upper surface of the channel is a flat plane.

3. The semiconductor device of claim 1 or 2, wherein the channel has a structure in which a plurality of 2D material layers are stacked, and a first number of the plurality of 2D material layers of the channel area is less than a second number of the plurality of 2D material layers of the contact area,
wherein the second number of the plurality of 2D material layers of the contact area is preferably 5 to 20.

4. The semiconductor device of one of claims 1 to 3, wherein the channel includes at least one of a transition metal dichalcogenide, TMD, material, graphene, black phosphorus, amorphous boron nitride, or phosphorene.

5. The semiconductor device of one of claims 1 to 4, wherein the patterning layer includes a high-k material or a ferroelectric material, or
wherein the patterning layer includes a first patterning layer on the substrate and a second patterning layer under the channel area, or
wherein a lower gate electrode is further located between the substrate and the patterning layer.

6. The semiconductor device of one of claims 1 to 5, wherein the channel includes a plurality of channel areas being apart from each other in a direction away from the substrate and a plurality of contact areas extending from the plurality of channel areas, respectively, and a distance from the lower surface of one of the plurality of channel areas to the upper surface of the substrate is greater than a distance from the lower surface of one of the plurality of contact areas extending from the one of the plurality of channel areas to the upper surface of the substrate,
wherein the contact area on a first side of each of the plurality of channel areas are preferably continuously connected to each other, and the contact area on a second side of each of the plurality of channel areas opposite to the first side are continuously connected to each other.

7. The semiconductor device of one of claims 1 to 6, wherein another patterning layer, another channel, another gate insulating film, and another gate electrode are further arranged on the gate electrode, and the another channel includes a material having a different conductivity type than that of a material of the channel.

8. A method of manufacturing a semiconductor device, the method comprising:
forming a patterning layer;
forming an adjustment layer on the patterning layer;
forming a channel by depositing a precursor of a two-dimensional material on the patterning layer and the adjustment layer;
forming a source electrode and a drain electrode on the channel;
forming a gate electrode over the source electrode and the drain electrode;
and
forming a gate insulating film between the channel and the gate electrode,
wherein the adjustment layer includes a material having a relatively low adsorption capacity with respect to the precursor of the two-dimensional material, compared to the patterning layer, and
the adjustment layer includes a plurality of adjustment layers having different thicknesses.

9. The method of claim 8, further comprising:
removing the adjustment layer.

10. The method of claim 8 or 9, wherein the adjustment layer includes a plurality of thicker adjustment layers and a thinner adjustment layer between an adjacent pair of the plurality of thicker adjustment layers,
wherein a pocket is preferably formed between one of the plurality of thicker adjustment layers and the thinner adjustment layer.

11. The method of one of claims 8 to 10, wherein the patterning layer includes a high-k material and a ferroelectric material.

12. The method of one of claims 8 to 11, wherein the adjustment layer includes at least one of SiO₂, Al₂O₃, SiN, or an amorphous carbon layer.

13. An electronic apparatus comprising:
a memory including the semiconductor device of one of claims 1 to 7; and
a memory controller configured to control the memory.

14. A semiconductor device comprising:
a substrate;
a first patterning layer on the substrate;
a plurality of vertically stacked channels on the first patterning layer, each of the plurality of vertically stacked channels including a two-dimensional, 2D, material, each of the plurality of vertically stacked channels including a channel area having a relatively thin thickness and a first contact area and a second contact area having a relatively thick thickness at both sides of the channel area, respectively, each of the plurality of vertically stacked channels including an upper surface and a lower surface closer to the substrate than the upper surface, the lower surface including a first lower surface portion of the channel area and a second lower surface portion of each of the first contact area and the second contact area, the second lower surface portion of each of the first contact area and the second contact area of one of the plurality of vertically stacked channels being in direct contact with the upper surface of another one of the plurality of vertically stacked channels that is immediately under the one of the plurality of vertically stacked channels;
a source electrode electrically connected to the first contact area of each of the plurality of vertically stacked channels;
a drain electrode electrically connected to the second contact area of each of the plurality of vertically stacked channels; and
a gate structure between the source electrode and the drain electrode, the gate structure including a gate insulating layer and a gate electrode, the gate structure enclosing each of the plurality of vertically stacked channels on top, bottom and lateral surfaces thereof, in a cross-section traversing from the source electrode to the drain electrode,
wherein each of the first contact area and the second contact area has a structure in which a plurality of first two-dimensional material layers are stacked in parallel, and the channel area has a structure in which a plurality of second two-dimensional material layers are stacked in parallel, and
a first stacking direction of the plurality of first two-dimensional material layers of each of the first contact area and the second contact area and a second stacking direction of the plurality of second two-dimensional material layers of the channel area are same.

15. The semiconductor device of claim 14, wherein the second lower surface portion of each of the first contact area and the second contact area of one of the plurality of vertically stacked channels is in direct contact with the upper surface of another one of the plurality of vertically stacked channels that is immediately under the one of the plurality of vertically stacked channels.
